# EUROPEAN PATENT SPECIFICATION

(11) **EP 4 324 097 B1**
(45) Date of publication and mention of the grant of the patent: **21.10.2026**
(21) Application number: 22723377.2
(22) Date of filing: 14.04.2022
(51) Int. Cl.: H03M 7/30, G06N 3/08

(54) **DECODER, ENCODER, METHOD AND COMPUTER PROGRAM FOR UPDATING NEURAL NETWORK PARAMETERS USING NODE INFORMATION**
DECODIERER, CODIERER, STEUERUNG, VERFAHREN UND COMPUTERPROGRAMM ZUR AKTUALISIERUNG VON PARAMETERN NEURONALER NETZWERKE UNTER VERWENDUNG VON KNOTENINFORMATIONEN
DÉCODEUR, CODEUR, PROCÉDÉ ET PROGRAMME INFORMATIQUE POUR METTRE À JOUR DES PARAMÈTRES DE RÉSEAU NEURONAL EN UTILISANT DES INFORMATIONS DE NOEUD

(30) Priority: 16.04.2021 EP 21169029
(43) Date of publication of application: 21.02.2024
(60) Divisional application: 26204976.0; 26204980.2
(73) Proprietor: Fraunhofer-Gesellschaft zur Förderung der angewandten Forschung e.V., 80686 München (DE)
(72) Inventor: KIRCHHOFFER, Heiner, 10587 Berlin (DE); MÜLLER, Karsten, 10587 Berlin (DE); HAASE, Paul, 10587 Berlin (DE); BECKING, Daniel, 10587 Berlin (DE); TECH, Gerhard, 10587 Berlin (DE); SAMEK, Wojciech, 10587 Berlin (DE); SCHWARZ, Heiko, 10587 Berlin (DE); MARPE, Detlev, 10587 Berlin (DE); WIEGAND, Thomas, 10587 Berlin (DE)
(74) Representative: Burger, Markus
(86) International application number: PCT/EP2022/060122
(87) International publication number: WO 2022/219158

(56) References cited:
- WO-A1-2019/219846
- WO-A1-2020/190772
- US-A1- 2017 132 515
- BECKING D ET AL: "[NNR] Response to the Call for Proposals on incremental compression of neural networks for multimedia content description and analysis", no. m56621, 18 April 2021 (2021-04-18), XP030295111, Retrieved from the Internet <URL:https://dms.mpeg.expert/doc_end_user/documents/134_OnLine/wg11/m56621-v1-m56621.zip m56621_CfP_Response_ICNN_HHI.docx> [retrieved on 20210418]

## Description

### Technical Field

Embodiments according to the invention are related to decoders, encoders, methods and computer programs for updating neural network parameters using node information.

Further embodiments according to the invention are related to efficient signaling of neural network updates in distributed scenarios.

### Background of the Invention

Neural networks, NN, e.g. neural nets, are used in a wide variety of application areas. In order to provide a good performance, for example complex and computationally expensive, training techniques have been developed. In order to carry out such a training process on a dedicated training device neural network parameters may have to be transmitted, for example, from an end user device to the training device and vice versa. Furthermore, efficient neural network parameter representation and parameter transmission techniques may be even more important in distributed learning scenarios in which a plurality of devices may train a neural network and updated parameters of respective training processes may be aggregated using a central server. Examples of such techniques are provided by WO 2019/219846 A1 (FRAUNHOFER GES FORSCHUNG [DE]), 21 November 2019 (2019-11-21).

Therefore, it is desired to get a concept which allows an efficient representation and transmission of neural network parameters for learning or updating processes.

This is achieved by the subject matter of the independent claims of the present application.

Further embodiments according to the invention are defined by the subject matter of the dependent claims of the present application.

### Summary of the Invention

Embodiments according to the invention comprise a decoder for decoding parameters of a neural network, wherein the decoder is configured to obtain a plurality of neural network parameters of the neural network on the basis of an encoded bitstream, according to independent claim 1. Preferred embodiments of said decoder are defined in dependent claims 2-20.

Embodiments according to the invention are based on the main idea to provide an efficient representation of neural network parameters based on a parameter update tree.

The inventors recognized that for updating or alternating neural networks, it may not be necessary to transmit/receive all parameters of a neural network. Instead, only an update information, or in other words a (neural network) parameter update information may be encoded/decoded and transmitted/received. In order to make use of such a for example differential information or for example difference information, an information about a set of reference parameters to be adapted using the update information, e.g. comprising change values, may be provided. The inventors recognized that such an information may be represented using a node information, the node information comprising the parameter update information and a parent node identifier, which may, for example, act as a pointer to the set of reference parameters to be adjusted.

A decoder according to the claimed invention comprises an information about a parameter update tree, the parameter update tree comprising one or more nodes that are in a hierarchical, order.

In order to determine one or more neural network parameters of an updated or trained neural network the decoder may hence receive the beforementioned node information or may extract the node information from an encoded bitstream, provided to the decoder. Using the parent node identifier, the decoder may select a specific node in the parameter update tree.

As an example, neural network parameters associated with the selected node, e.g. associated with a specific version of the neural network represented by the node, may be stored within the node. Hence, the decoder may adapt or adjust or update these stored neural network parameters using the parameter update information in order to determine updated neural network parameters, and for example hence an updated version of the neural network represented by the selected node. As an example, a new node may be added to the update tree, using the parent node identifier and the parameter update information of the received or extracted node information. The new node may, for example, comprise or represent the updated neural network parameters.

The selected node comprises an own parent node identifier and an own parameter update information. Hence, the decoder recursively derives predecessor nodes of the selected node until a node, e.g. a root node or a source node, is reached for which neural network parameters are available (e.g. instead of a pointer to a reference information and update values). Hence, these neural network parameters are updated based on the parameter update information of the derived nodes, the selected node and finally the parameter update information of the received or extracted node information.

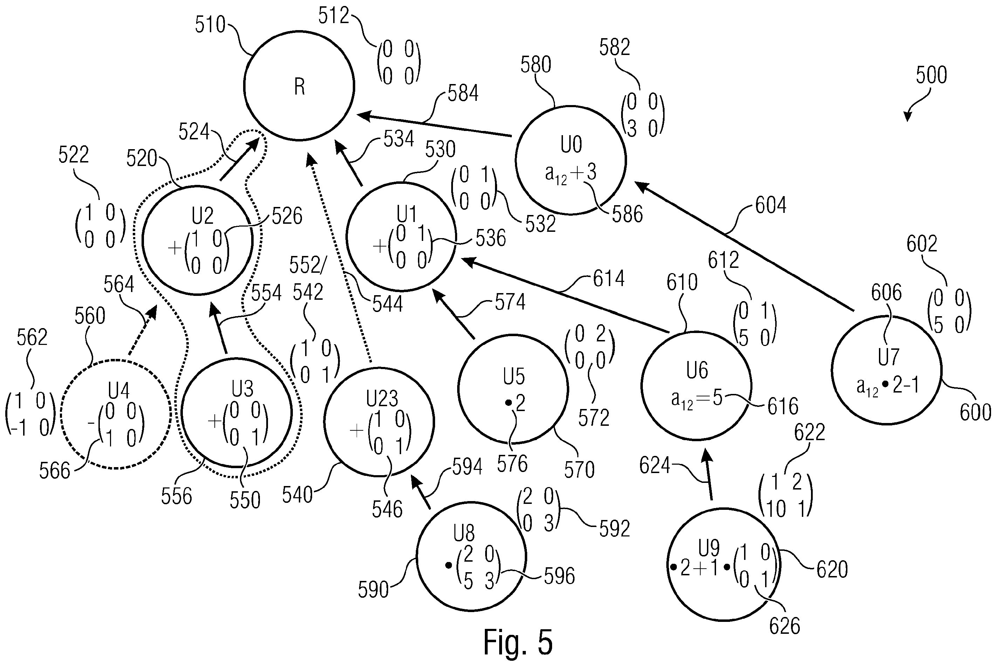

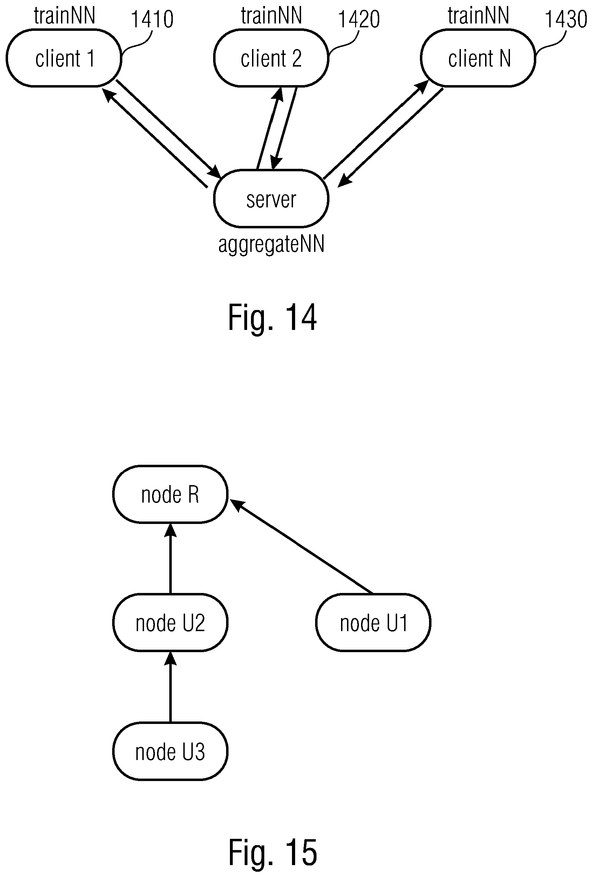

In the following further embodiments according to the invention are discussed. Optional examples and explanations with regard to specific nodes may be related to two arbitrary nodes, e.g. nodes U2 and U3, or to the nodes as shown in Fig. 5 and/or Fig. 15, which will be explained in detail later.

Further embodiments according to the invention comprise an encoder for encoding parameters of a neural network in order to obtain an encoded bitstream, according to claim 21.

The inventors recognized that this way, a recursively usable parameter update tree may be provided, such that update or differential information may be encoded and transmitted and hence evaluated efficiently.

Further embodiments according to the invention comprise a method for decoding parameters of a neural network, according to claim 22.

Further embodiments according to the invention comprise a method for encoding parameters of a neural network in order to obtain an encoded bitstream, according to claim 23.

Further embodiments according to the invention comprise a computer program for performing a method according to any of the embodiments as disclosed herein, when the computer program runs on a computer, as defined by claim 24.

### Brief Description of the Drawings

The drawings are not necessarily to scale, emphasis instead generally being placed upon illustrating the principles of the invention. In the following description, various examples are described with reference to the following drawings, in which:
- Fig. 1a: shows a schematic view of a decoder according to an embodiment of the present invention;
- Fig. 1b: shows a schematic view of a decoder with a generalized node information according to an embodiment of the present invention;
- Fig. 2: shows a schematic view of an encoder according to an embodiment of the present invention;
- Fig. 3a: shows a schematic view of another encoder according to an embodiment of the present invention;
- Fig. 3b: shows a schematic view of an encoder with a generalized node information according to an embodiment of the present invention;
- Fig. 4: shows a schematic view of a further encoder according to an embodiment of the present invention.
- Fig. 5: shows an example, of a parameter update tree, PUT, according to embodiments of the invention;
- Fig. 6: shows a schematic example of a tensor shape conversion according to embodiments of the invention;
- Fig. 7: shows an example for a topology change of a neural network according to embodiments of the invention;
- Fig. 8: shows a schematic view of a neural network controller according to embodiments of the invention;
- Fig. 9: shows a schematic view of a neural network federated learning controller according to embodiments of the invention;
- Fig. 10: shows a schematic block diagram of a method for decoding parameters of a neural network according to embodiments of the invention;
- Fig. 11: shows a schematic block diagram of a method for encoding parameters of a neural network in order to obtain an encoded bitstream according to embodiments of the invention;
- Fig. 12: shows a schematic block diagram of a method for controlling a neural network according to embodiments of the invention;
- Fig. 13: shows a schematic block diagram of a method for controlling neural network federated learning according to embodiments of the invention;
- Fig. 14: shows a schematic view of an example of federated learning scenario according to embodiments of the invention; and
- Fig. 15: shows a schematic view of an example of parameter update tree, for example exemplary parameter update tree, according to embodiments of the invention.

### Detailed Description of the Embodiments

Equal or equivalent elements or elements with equal or equivalent functionality are denoted in the following description by equal or equivalent reference numerals even if occurring in different figures.

In the following description, a plurality of details is set forth to provide a more throughout explanation of the present invention. However, it will be apparent to those skilled in the art that embodiments of the present invention may be practiced without these specific details. In other instances, well-known structures and devices are shown in block diagram form rather than in detail in order to avoid obscuring embodiments of the present invention. In addition, features of the different embodiments described herein after may be combined with each other, unless specifically noted otherwise. The scope of the invention is defined by the appended claims.

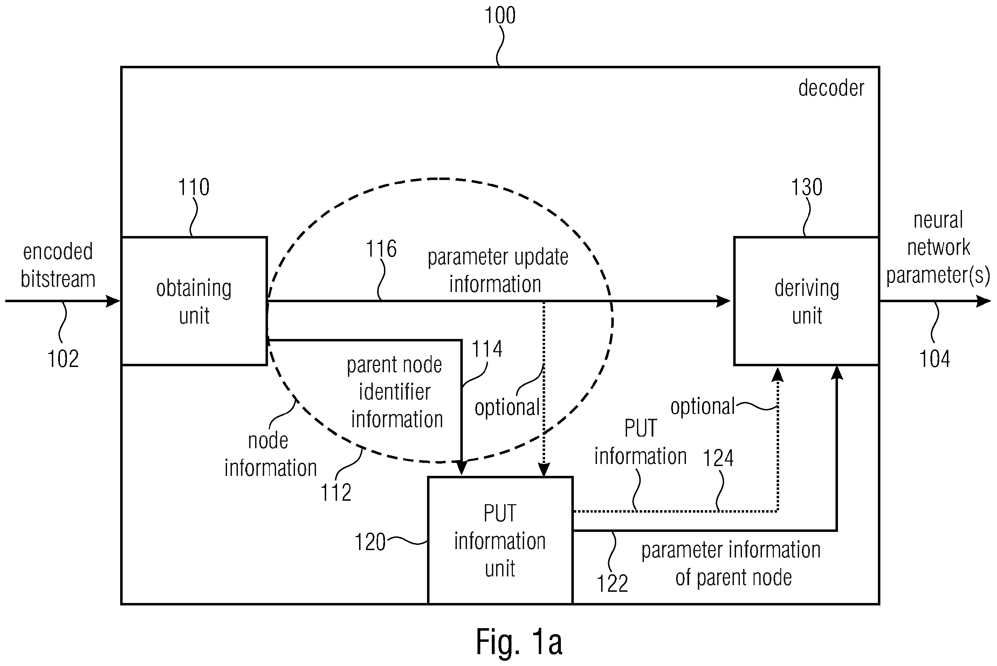

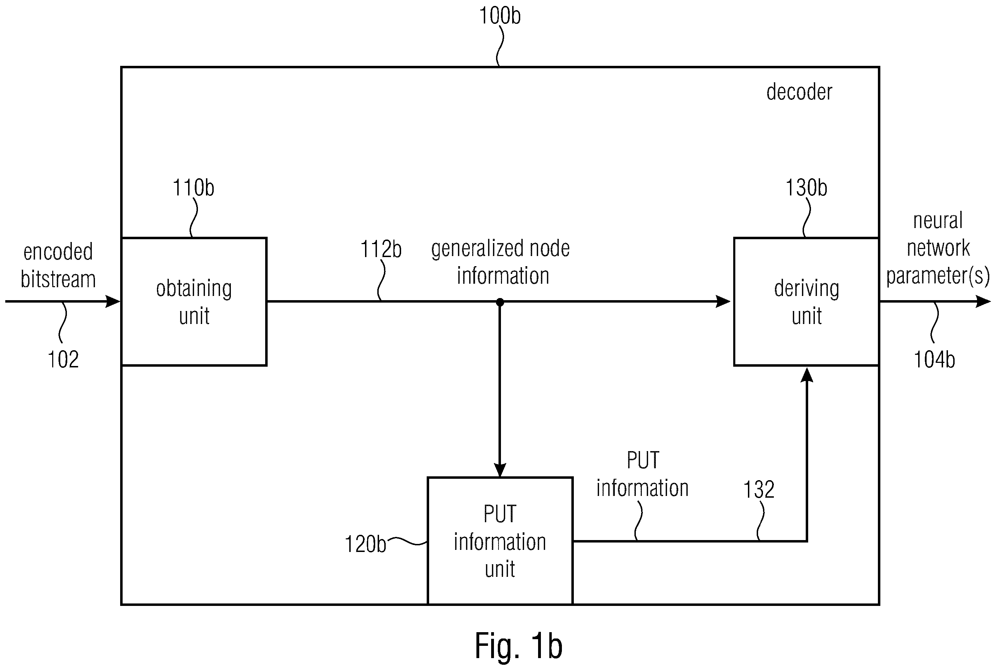

Fig. 1a shows a schematic view of a decoder according to an embodiment of the present invention. Fig. 1 shows decoder 100 comprising an obtaining unit 110, a parameter update tree, PUT, information unit 120 and a deriving unit 130.

The decoder 100 may receive an encoded bitstream 102, based on which, as an example, obtaining unit 110 may determine a node information 112. The node information 112 may describe a node of a parameter update tree, PUT. The node information 112 comprises a parent node identifier information 114, optionally comprising or for example being a parent node identifier, and a parameter update information 116.

Using the parent node identifier information 114, the PUT information unit 120 may be configured to determine a parameter information 122 of a parent node, identified by the parent node identifier information 114.

Using the parameter update information 116 and the parameter information 122, the deriving unit 130 may derive one or more neural network parameters 104.

In simple words, an information about neural network parameters may be provided using node information 112, comprising parent node identifier information 114 and parameter update information 116, encoded in the encoded bitstream 102. Hence, a parent node identifier and the parameter update information 116 may be extracted by obtaining unit 110. For example, instead of encoding the neural network parameters themselves, a reference information in the form of the parent node identifier information 114 and an update information in the form of the parameter update information 116 may be provided.

The reference information may be identified and/or extracted using PUT information unit 120, e.g. based on a parameter update tree. The idea according to embodiments may now be to extract neural network parameters of the parent node in the form of the parameter information 122 and to update this information using the parameter update information 116 in deriving unit 130.

In other words, neural network parameter(s) 104 of a current node may be derived using neural network parameters of a parent node of the current node that are modified by the parameter update information 116 using deriving unit 130.

As an optional feature, the parameter update information 116 may, for example, be provided to the PUT information unit 120.

As another optional feature, the PUT information unit 120 may be configured to provide a PUT information 124 to the deriving unit 130. The PUT information 124 may optionally comprise an information about the parameter update tree.

Fig. 1b. shows decoder 100b comprising an obtaining unit 110b, a PUT information unit 120b and a deriving unit 130b. The obtaining unit 110b may, for example, be configured to obtain a generalized node information 112b. Information 112b may optionally be equal or similar to node information 112, e.g. comprising a parent node identifier information and a parameter update information. However, generalized node information 112b may optionally comprise additional information, for example, such as a node identifier and/or a signaling whether a node identifier is present or not and/or a signaling comprising an information about a type of a parent node identifier, for example, in the form of a syntax element, a topology change information and/or a topology change signaling, as will be explained in detail henceforth.

Furthermore, PUT information unit 120b may provide a PUT information 132 to deriving unit 130b. PUT information 132 may, for example, be the parameter information of the parent node 122 as shown in Fig. 1. Optionally, update tree information 132 may comprise optional PUT information, e.g. 124 (referring to Fig. 1).

Accordingly, obtaining unit 110b may be configured to obtain or provide such a generalized node information 112b from an encoded bitstream 102, and the PUT information unit 120b may be configured to provide or determine the update tree information 132, e.g. based on a PUT, using the generalized node information 112b.

The deriving unit 130b, may hence be configured to derive one or more neural network parameters 104b using the generalized node information 112b and the PUT information 132.

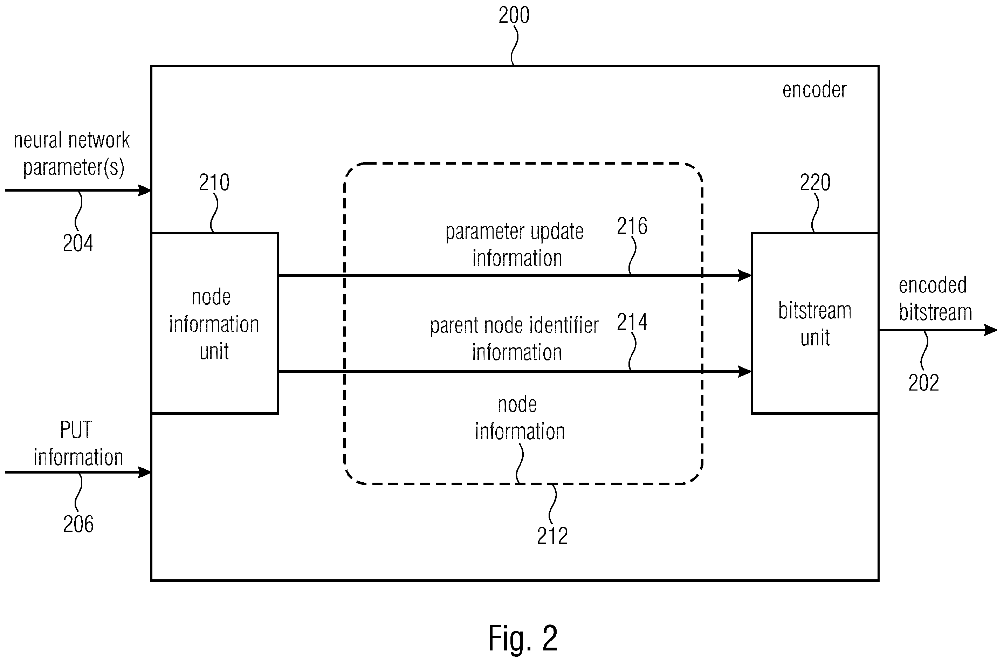

Fig. 2 shows a schematic view of an encoder according to an embodiment of the present invention. Fig. 2 shows encoder 200 comprising a node information unit 210 and a bitstream unit 220.

As shown in Fig. 2 the encoder 200 may optionally receive neural network parameter(s) 204 and/or a parameter update tree, PUT, information 206. Based on the neural network parameter(s) 204 and the PUT information 206, node information unit 210 may provide a node information 212 describing a node of a parameter update tree. Node information 212 comprises a parent node identifier information 214, optionally comprising a parent node identifier, and a parameter update information 216, wherein the parameter update information 216 describes differences between neural network parameters associated with a parent node defined by the parent node identifier information 214 and current neural network parameters 204.

Using the node information 212 the bitstream unit 220 may provide an encoded bitstream 202, the bitstream comprising encoded neural network parameters 204.

As an example, as shown in Fig. 2, the idea of encoder 200 may be to encode neural network parameters(s) 204 not simply with their respective values, but using a reference and a differential or difference information with regard to the reference. The reference may be a set of neural network parameters identified by a parent node of a parameter update tree, indicated by parent node identifier information 214. The differential or difference information of the neural network parameters 204 with respect to neural network parameters of the parent node may be the parameter update information 216.

Therefore, encoded bitstream 202 may allow a corresponding decoder that may have an information about the parameter update tree available to identify a corresponding parent node, and hence neural network parameters thereof, to adapt or to modify those in order to determine neural network parameter(s) 204.

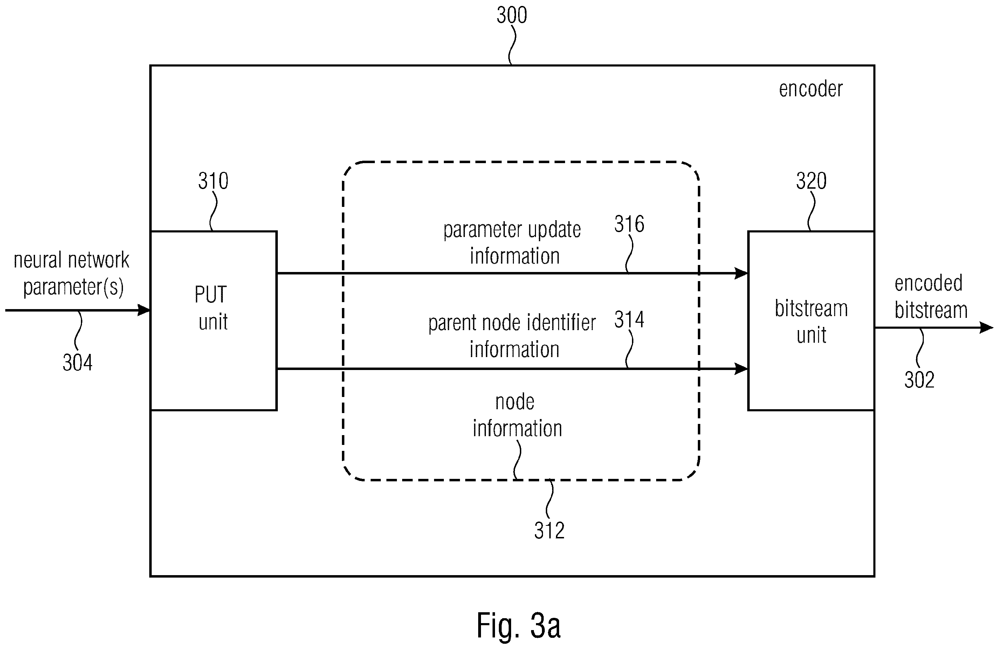

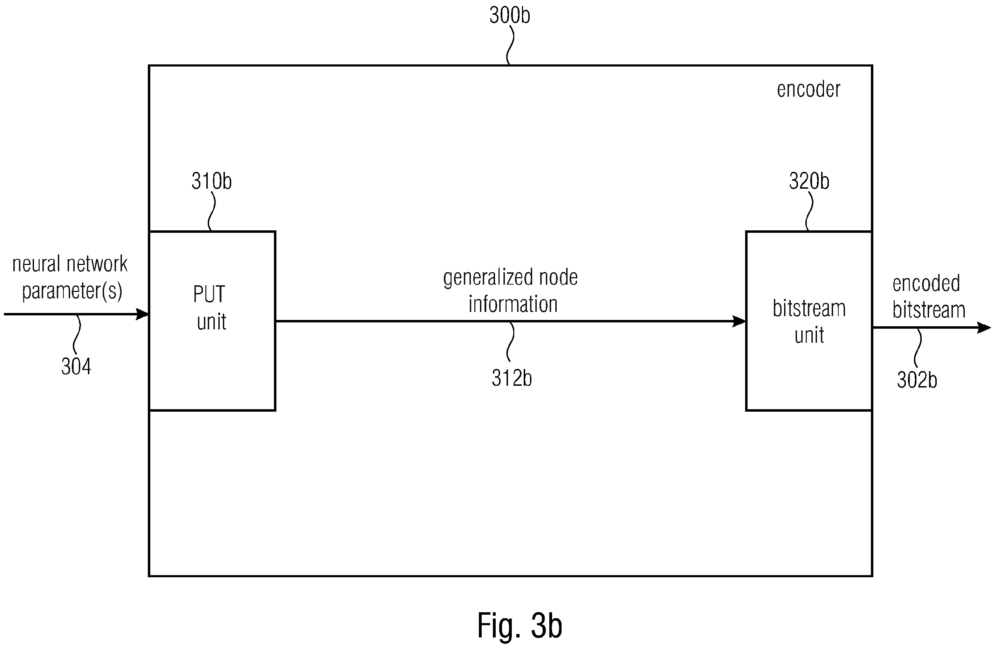

Fig. 3a shows a schematic view of another encoder according to an embodiment of the present invention. Fig. 3 shows encoder 300 comprising a parameter update tree, PUT, unit 310 and a bitstream unit 320.

In this example, encoder 300 may receive neural network parameter(s) 304. In order to encode the parameter(s) 304 encoder 300 may determine node information 312 comprising parent node identifier information 314, optionally. comprising a parent node identifier, and parameter update information 316, using PUT unit 310, for example, such that parameter(s) 304 may be represented as neural network parameters of a parent node (represented as the parent node identifier information 314) of a parameter update tree and a modification or update information (represented as the parameters update information 316).

As explained in the context of Fig. 2 bitstream unit 320 may encode the node information 312 in an encoded bitstream 302. As an example, encoder 300, e.g. in contrast to encoder 200 may be configured to provide node information 312 based on the parameters 304 as, for example only, input signal. Therefore, the PUT unit 310 may comprise a parameter update tree information in order to provide an alternative representation of the parameters 304 in the form of the update information 316 and an identifier.

Fig. 3b shows a schematic view of an encoder with a generalized node information according to an embodiment of the present invention. Fig. 3b shows encoder 300b comprising a parameter update tree, PUT, unit 310b and a bitstream unit 320b. PUT unit 310b may be configured to provide the generalized node information 312b based on or using neural network parameter(s) 304, wherein information 312b may optionally be equal or similar to node information 312, e.g. comprising a parent node identifier information and a parameter update information.

However, generalized node information 312b may optionally comprise additional information, for example, such as a node identifier and/or a signaling whether a node identifier is present or not and/or a signaling comprising an information about a type of a parent node identifier, for example, in the form of a syntax element, a topology change information and/or a topology change signaling, as will be explained in detail henceforth.

Using the generalized node information 312b the bitstream unit 320b may provide an encoded bitstream 302b.

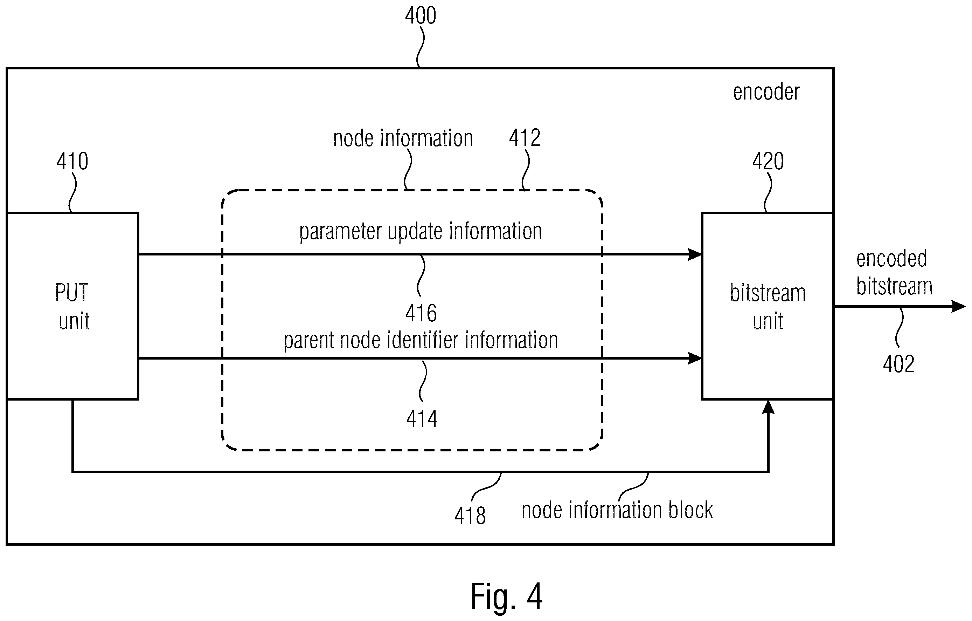

Fig. 4 shows a schematic view of a further encoder according to an embodiment of the present invention. Fig. 4 shows encoder 400 comprising a PUT unit 410 and a bitstream unit 420.

As an optional example, PUT unit 410 may comprise a parameter update tree, e.g. as explained in the context of Fig. 5. The PUT unit 410 may provide a node information 412, comprising a parent node identifier information 414, optionally comprising a parent node identifier, and a parameter update information 416, that is provided to the bitstream unit 420 to obtain an encoded bitstream 402. Current neural network parameters e.g. associated with a specific node of the parameter update tree may hence be encoded in the form of the parent node identifier information 414, providing an information about reference parameters and of the parameter update information 416 providing an information on how to modify the reference parameters, in order represent the current neural network parameters associated with the node. Accordingly, the parameter update information 416 may describe differences between neural network parameters associated with a parent node defined by the parent node identifier and the current neural network parameters.

As an optional feature, encoder 400, e.g. PUT unit 410, may be configured to provide a plurality of node information blocks 418, wherein a parent node identifier of a first node information block refers to a root node and wherein a parameter update information of the first node describes differences between neural network parameters associated with the root node defined by the parent node identifier of the first node information block, and neural network parameters of the first node, and wherein a parent node identifier of a N-th node information block refers to a N-1-th node and wherein a parameter update information of the N-th node describes differences between neural network parameters associated with the N-1-th node defined by the parent node identifier of the N-th node information block, and neural network parameters of the N-th node.

In simple words, encoder 400 may be configured to provide, e.g. via encoded bitstream 402 an information about a respective parameter update tree.

Fig. 5 shows an example, of a parameter update tree, PUT, according to embodiments of the invention. Fig. 5 shows PUT 500 comprising a root node R 510 and a plurality of child nodes, to name some as examples 520, 530 ,540, 550, 560.

As a simplified example, root node R, 510, may correspond to a set of four neural network parameters a₁₁=a₁₂=a₂₁=a₂₂=0, as an example, represented by a tensor 512. a₁₁, a₁₂, a₂₁, a₂₂ may, for example, be parameter values associated with the node R.

Hence, accordingly, a child node U1, 530, may correspond to a set of four neural network parameters, e.g. parameter values, a₁₁=a₁₂= a₂₂=0 and a₂₁=1, as an example, represented by a tensor 532.

The idea according to embodiments may now be the following: Instead of transmitting all four neural network parameters a₁₁=a₁₂= a₂₂=0 and a₂₁=1, only a reference information in the form of a parent node identifier 534 and a parameter update information 536 may be transmitted. In the simplified example of Fig. 5 the parameter update information 536 may be four change values, as an example represented by an additive tensor 536. In many applications, many NN parameters may not change drastically in between training cycles, hence as shown with tensor 536 many change values may be zero or quantized to zero. Hence such an update information may be encoded efficiently (e.g. compression of zeros).

Hence, if an encoder and a corresponding decoder both comprise an information about neural network parameters associated with root node R, 510, for example initial neural network parameters or default neural network parameters, then it may not be necessary to fully encode neural network parameters 532 associated with node U1, 530, e.g. neural network parameters after a first training step of a neural network, but only a reference information 534 and a difference information 536.

Hence, an encoder may transmit a node information in an encoded bitstream comprising parameter update information 536 and parent node identifier 534, such that a corresponding decoder may determine neural network parameters 532 as a sum, e.g. an elementwise-sum, of the neural network parameters 512 associated with the root node R, 510, identified by the parent node identifier 534, and the parameter update information 536, for example, such that tensor 512 + tensor 536 = tensor 532.

Accordingly, node U2, 520, may be associated with neural network parameters 522, wherein a parent node of U2 is node R, 510, such that parent node identifier 524 may be a pointer towards root node R, 510.

Node 540, associated with neural network parameters 542, may as well be a child node of node R, 510, such that parent node identifier 544 may as well be a pointer towards root node R, 510.

In contrast, nodes 550, 560 may be child nodes of node U2, 520, hence their parent node identifiers 554, 564 may identify U2, 520. U3, 550, may be associated with neural network parameters 552, and comprise parameter update information 556, with respect to its parent node U2, 520. Vice versa, U4, 560 may be associated with neural network parameters 562, and may comprise parameter update information 566, with respect to its parent node U2, 520.

The further elements of Fig. 5 will be explained in more detail step by step with regard to further embodiments of the invention. In the following further embodiments according to the invention are explained in the context of Figs. 1 to 5.

Accordingly to the above explanation, as an optional feature, an encoder, e.g. 200, 300, 300b and/or 400, may be configured determine differences, e.g. using node information unit 210 or PUT unit 310, 310b, 410, between one more neural network parameters, e.g. 512, defined by the parent node, e.g. R, 510, which is identified by the parent node identifier, e.g. 534, and one or more current neural network parameters, e.g. 532, in order to obtain the parameter update information, e.g. 536.

As another optional feature, an inventive decoder, e.g. 100, 100b, e.g. PUT information unit 120, 120b, and/or an inventive encoder, e.g. 200, 300, 300b and/or 400 for example node information unit 210 and/or PUT unit 310, 310b, 410, may optionally be configured to set up a parameter update tree 500, wherein a plurality of child nodes (to name only some, for example 520, 530 ,540, 550, 560) comprising different parameter update information (e.g. 526, 536, 546, 556, 566) are associated with a common parent node, e.g. R, 510. Hence, as shown in Fig. 5 some nodes, e.g. U3, 550 and U4, 560, may be associated with the common parent node R via different, e.g. intermediate nodes, e.g. U2, 520.

As an example, an inventive PUT information unit, e.g. 120, 120b, may comprise the parameter update tree and/or may, for example, be configured to set the parameter update tree up. Therefore, the PUT information unit may, as explained before, optionally receive the parameter update information 116, in order to set up or to update a corresponding PUT.

An inventive encoder, e.g. 200, 300, 300b and/or 400, may, for example, be configured to set up a PUT using the node information unit 210 or a PUT unit 310, 310b and/or 410 respectively. These units may be configured to set up, store and/or update a PUT.

As another optional feature, an inventive encoder, e.g. 200, 300, 300b and/or 400 for example node information unit 210 and/or PUT unit 310, 310b, 410, may optionally be configured to provide the node information 212, 312, 312b and/or 412 (for example a node information comprising a parameter update information 556 and a parent node identifier 554), such that it is possible to obtain one or more neural network parameters, e.g. 552 associated with a currently considered node, e.g. U3, 550, using the parameter update information, e.g. 556, associated with the currently considered node, using a parameter information, e.g. 512, associated with a root node, e.g. R, 510, and using parameter update information, e.g. 526, associated with one or more intermediate nodes, e.g. U2, 520, which are between the root node and the currently considered node in the update tree.

Hence, as an example, in order to obtain neural network parameter associated with node U3, 550, the neural network parameters 512 of the root node R, 510 may be modified according to the tree path R-U2-U3 using parameter update information 526 and 556, such that tensor 512 + tensor 526 + tensor 556 = tensor 552 (as an example, with an elementwise summation) representing the neural network parameters of node U3.

Accordingly, as an optional feature, an inventive decoder, e.g. 100, 100b, e.g. deriving unit 130, 130b, may be configured to obtain one or more neural network parameters, e.g. 104, 104b, for example corresponding to 552, associated with a currently considered node, e.g. U3, 550, using the parameter update information, e.g. 556, associated with the currently considered node, using a parameter information, e.g. 512, associated with a root node, e.g. R, 510, and using parameter update information, e.g. 526, associated with one or more intermediated nodes, e.g. U2, 520, which are between the root node and the currently considered node in the update tree.

Therefore, for example when the PUT information unit 120, 120b comprises an information about the PUT, PUT information unit 120, 120b may provide the PUT information 132 (or the optional information 124) comprising parameter update information, e.g. 526, and optionally parent node identifiers, e.g. 524, of intermediate nodes, e.g. U2, 520, to the deriving unit, e.g. 130, 130b, to obtain the one or more neural network parameters, e.g. 104, 104b for example corresponding to 552. In this case, as an example, encoded bitstream 102 may only comprise a parameter update information, e.g. 556, and a parent node identifier, e.g. 554, of the currently considered node (which may be used in conjunction with a PUT to determine a path through the PUT to determine the neural network parameters, e.g. 552, of the currently considered node, e.g. U3, 550).

As another, e.g. alternative, optional feature, the encoded bitstream 102 may comprise an information about the PUT, e.g. 500, and/or for example information about a path of the PUT, e.g. R-U2-U3, such that the parameter update information, e.g. 116, provided by obtaining unit, e.g. 110, 110b, may comprise the parameter update information, e.g. 556 and 526, of the currently considered node, e.g. U3, 560, and an intermediate node, e.g. U2, 520. Accordingly, parent node identifiers, e.g. 554 and 524, may be provided.

Accordingly, an inventive encoder, e.g. 200, 300, 300b and/or 400, may be configured to provide such an encoded bitstream 202, 302, 302b and/or 403 comprising a parameter update information and parent node identifiers of currently considered nodes and intermediate nodes..

Furthermore, as another optional feature, e.g. PUT information unit 120, 120b, comprising a PUT, e.g. 500, may, for example, be configured to traverse the parameter update tree, e.g. 500 (for example using PUT information unit 120, 120b), from a root node, e.g. R, 510, to a currently considered node, e.g. U3, 550, and to apply update instructions, e.g. 526, of visited nodes, e.g. U2, 520, to one or more initial neural network parameters, e.g. 512, in order to obtain one or more neural network parameters, e.g. 552, associated with the currently considered node, e.g. U3, 550.

As another optional feature, an inventive decoder, e.g. 100, 100b, e.g. PUT information unit 120, 120b, comprising a PUT, e.g. 500, may, for example, be configured to aggregate a plurality of consecutive nodes, e.g. nodes U2, 520, and U3, 550, of the parameter update tree, e.g. 500 and/or one or more consecutive nodes, e.g. nodes U2, 520, and U3, 550, of the parameter update tree and the parameter update information, e.g. 526, 556.

Hence, as shown in Fig. 5, nodes U2, 520, and U3, 550 may be aggregated or merged together to a new node U23, 540. Therefore, neural network parameters associated with U3, namely parameters 552 may be equal to neural network parameters associated with U23, namely parameters 542. Consequently, parameter update information 546 of node U23 may be a combination (in the simple example of Fig. 5 an elementwise sum) of parameter update information 526 and 556. Accordingly, parent node identifier 544 may point to the same node or may be equal to parent node identifier 524.

As another optional feature, an inventive decoder, e.g. 100, 100b, e.g. PUT information unit 120, 120b, may optionally be configured to update the parameter update tree, e.g. 500, based on the node information, e.g. 112, 112b. As an example, PUT information unit 120, 120b may optionally comprise the information about the parameter update tree, e.g. 500. The parameter update tree may be adapted by, for example, adding a new node, for example a node U4, 560, to the parameter update tree. This may comprise adding a corresponding parent node identifier, e.g. 564. Optionally, parameter update information 116 may be proved to PUT information unit 120, 120b as well, such that parameter update information 116, e.g. corresponding to tensor 566, may be added to the PUT as well. Hence, information about the new node, e.g. U4, 560, namely the parameter update information, e.g. 566, and the parent node identifier, e.g. 564, may be provided in the bitstream, e.g. 102, optionally, with a signaling to indicate that a new node is to be added. Alternatively, an inventive decoder, e.g. 100, may be configured to add such a node autonomously.

As another optional feature, an inventive decoder 100, 100b may be configured to decide to choose neural network parameters associated with a root node, e.g. R, 510, or to choose neural network parameters associated with one of the descendent nodes of the root node.

Accordingly, an inventive encoder, e.g. 200, 300, 300b and/or 400 for example bitstream unit 220, 320, 320b, 420, may optionally be configured to provide a signaling, e.g. the encoded bitstream 202, 302, 302b, and/or 402, or a signal encoded in the encoded bitstream, to a decoder, e.g. 100, 100b, to selectively choose neural network parameters associated with a root node, e.g. R, 510, or neural network parameters associated with one of the descendent nodes of the root node.

As mentioned before, the elementwise sums of tensors, as explained above, may only be one e.g. simple example for the handling of parameter update information according to embodiments of the invention.

Parameter update tree 500 further comprises a node U5, 570, associated with parameter values, e.g. neural network parameters, 572, optionally in the form of a tensor, as shown in Fig. 5. Node U5, 570, is a child node of node U1, 530, as indicated by parent node information 574. As another optional feature, parameter update information 576 of node U5 comprises a scaling.

Hence, as another optional feature, the parameter update information 116, 216, 316 and/or 416 may, for example, comprise an update instruction defining a scaling of one or more parameter values associated with a parent node of a currently considered node.

Furthermore, an inventive decoder, e.g. 100, 100b, e.g. deriving unit 130, 130b, may optionally be configured to apply a scaling defined by the update instruction, e.g. 576, in order to obtain one or more neural network parameters, e.g. 104, 104b, for example corresponding to tensor 572, associated with the currently considered node, e.g. U5, 570, and correspondingly, an inventive encoder, e.g. 200, 300, 300b and/or 400 for example node information unit 210 or PUT unit 310, 310b, 410, may be configured to determine the scaling on the basis of one or more parameter values associated with a parent node, e.g. U1, 530 of the currently considered node and parameter values, e.g. 572, of a currently considered node, e.g. U5.

For explanatory purposes, in simple words, scaling 576 may indicate to double the parameter values 532 of parent node U1 in order to obtain the parameter values 572 of node U5.

Parameter update tree 500 further comprises a node U0, 580, associated with parameter values, e.g. neural network parameters, 582, optionally in the form of a tensor, as shown in Fig. 5. Node U0, 580, is a child node of node R, 510, as indicated by parent node information 584. As another optional feature, parameter update information 586 of node U0 comprises an additive change value, e.g. +3.

Hence, as an optional feature, the parameter update information116, 216, 316 and/or 416 (and accordingly generalized node information 112b, 312b) may comprise an update instruction defining an addition of one or more change values, e.g. a change value 3, to one or more parameter values, e.g. a₁₂ of tensor 512, associated with a parent node, e.g. R, 510, of a currently considered node, e.g. U0, 580, and/or a subtraction of one or more change values from one or more parameter values associated with a parent node of a currently considered node.

Therefore, an inventive decoder, e.g. 100, 100b, e.g. deriving unit 130, 130b, may optionally be configured to apply an addition or subtraction of the change values defined by the update instruction, in order to obtain one or more neural network parameters associated with the currently considered node.

As an optional example, a tensor subtraction is shown in Fig. 5 with parameter update information 566 of node U4, 560. Hence, embodiments may comprise additions or subtractions, e.g. elementwise additions or subtractions, e.g. in tensor or matrix form.

Parameter update tree 500 further comprises a node U8, 590, associated with parameter values, e.g. neural network parameters, 592, optionally in the form of a tensor, as shown in Fig. 5. Node U8, 590, is a child node of node U23, 540, as indicated by parent node information 594. As another optional feature, parameter update information 596 of node U8 is a product tensor.

In other words, optionally, a plurality of neural network parameters, e.g. 592, associated with a currently considered node, e.g. U8, may be represented by a parameter tensor and an inventive decoder, e.g. 100, e.g. deriving unit 130, 130b may optionally, be configured to apply a product tensor, e.g. 596, to a parameter tensor, e.g. 542, in order to obtain the parameter tensor, e.g. 592, associated with the currently considered node, e.g. 590, for example, as shown as a simple variant, using or performing or based on an elementwise multiplication of tensor elements.

Accordingly, an inventive encoder, e.g. 200, 300, 300b and/or 400 for example node information unit 210 or PUT unit 310, 310b, 410, may be configured to provide a product tensor, e.g. 596, for application to a parameter tensor, e.g. 542, in order to obtain a parameter tensor, e.g. 592, associated with the currently considered node, e.g. U8, 590.

Furthermore, as another optional feature, a plurality of neural network parameters associated with a parent node may be represented by a parameter tensor, and the parameter update information 116, 216, 316 and/or 416 (and accordingly generalized node information 112b, 312b) may optionally, comprise a product tensor, e.g. 596.

Moreover, an inventive decoder, e.g. 100, 100b, e.g. deriving unit 130, 130b, may optionally be configured to apply the product tensor, e.g. 596, to the parameter tensor, e.g. 542, of the parent node, e.g. 540, in order to obtain a parameter tensor, e.g. 592, associated with the currently considered node, e.g. U8, 590.

Accordingly, an inventive encoder, e.g. 200, 300, 300b and/or 400, for example node information unit 210 and/or PUT unit 310, 310b, 410, may be configured to provide the product tensor, e.g. 596, in such a manner, that an application of the product tensor to the parameter tensor, e.g. 542, of the parent node, e.g. 540, results in a parameter tensor, e.g. 592, associated with the currently considered node, e.g. U8, 590.

Parameter update tree 500 further comprises a node U7, 600, associated with parameter values, e.g. neural network parameters, 602, optionally in the form of a tensor, as shown in Fig. 5. Node U7, 600, is a child node of node U0, 580, as indicated by parent node information 604. As another optional feature, parameter update information 606 of node U8 is an update instruction defining a weighted combination of one or more parameter values, e.g. a₁₂ of 582, associated with a parent node, e.g. U0, 580, of the currently considered node, e.g. U7, 600, with one or more change values.

Hence, optionally, the parameter update information, e.g. 116, 216, 316 and/or 416 (and accordingly generalized node information 112b, 312b), may comprise an update instruction, e.g. 606, defining a weighted combination of one or more parameter values, e.g. a₁₂ of 582, associated with a parent node, e.g. U0, 580, of the currently considered node, e.g. U7, 600, with one or more change values.

Accordingly, an inventive decoder, e.g. 100, 100b, e.g. deriving unit 130, 130b, may optionally be configured to apply a weighted combination of one or more parameter values associated with a parent node of the currently considered node with one or more change values, in order to obtain one or more neural network parameters associated with the currently considered node.

Again, it is to be noted that any additional information required for a processing, an optional PUT information 124 may be provided by PUT information unit 120 to the deriving unit 130. Accordingly PUI information 132 may comprise such an additional information.

Parameter update tree 500 further comprises a node U6, 610, associated with parameter values, e.g. neural network parameters, 612, optionally in the form of a tensor, as shown in Fig. 5. Node U6, 610, is a child node of node U1, 530, as indicated by parent node information 614. As another optional feature, parameter update information 616 of node U6 is an update instruction defining a replacement of one or more parameter values, in this case the parameter value a₁₂ of tensor 532, associated with the parent node of U6 with one or more change values, in this case the one change value 5.

Hence, an inventive parameter update information 116, 216, 316 and/or 416 (and accordingly generalized node information 112b, 312b) may optionally comprise an update instruction, e.g. 616, defining a replacement of one or more parameter values associated with a parent node, e.g. U1, 530, of the currently considered node, e.g. U6, 610, with one or more change values.

Therefore, an inventive decoder, e.g. 100, 100b, e.g. deriving unit 130, 130b, may optionally be configured to replace one or more parameter values associated with a parent node of the currently considered node with one or more replacement values, in order to obtain one or more neural network parameters associated with the currently considered node.

Parameter update tree 500 further comprises a node U9, 620, associated with parameter values, e.g. neural network parameters, 612, optionally in the form of a tensor, as shown in Fig. 5. Node U9, 620, is a child node of node U6, 610, as indicated by parent node information 624.

As an optional feature, as shown with the example of U9, 620, a plurality of neural network parameters associated with a parent node of the currently considered node, e.g. U9, may be represented by a parameter tensor, e.g. 612, and a plurality of neural network parameters associated with a currently considered node may be represented by a parameter tensor, e.g. 622, and a plurality of change values may be represented by a sum tensor, e.g. sum tensor $\left(\begin{matrix}1 & 0 \\ 0 & 1\end{matrix}\right)$ of parameter update information 626.

Furthermore, as an example, an inventive encoder, e.g. 200, 300, 300b and/or 400 for example node information unit 210 and/or PUT unit 310, 310b, 410, may be configured to multiply elements of the parameter tensor, e.g. 612, associated with the parent node, e.g. U6, 610, of the currently considered node, e.g. U9, 620, with a node tensor weight value, e.g. as shown with factor •2 of parameter update information 626, to obtain a scaled parameter tensor, to multiply elements of the sum tensor, e.g. sum tensor $\left(\begin{matrix}1 & 0 \\ 0 & 1\end{matrix}\right)$ of parameter update information 626, with a sum tensor weight value, e.g. weight value 1, as shown with parameter update information 626, to obtain a scaled sum tensor, and form an element-wise sum of the scaled parameter tensor and of the scaled sum tensor, in order to obtain the parameter tensor, e.g. 622, associated with the currently considered node, e.g. U9.

It is to be noted that embodiments according to Fig. 5 may be simple embodiments, for explanatory purposes, such that, for example significantly more complex, parameter update information may be used in order to represent a specific version of neural network parameters.

As an optional feature, e.g. as explained before, a plurality of neural network parameters associated with a parent node of a currently considered node may be represented by a parameter tensor, and the parameter update information 116, 216, 316 and/or 416 (and accordingly generalized node information 112b, 312b) may optionally comprise an update instruction in the form of an update tensor.

Furthermore, an inventive decoder, e.g. 100, 100b, e.g. deriving unit 130, 130b, may optionally be configured to convert the shape of the update tensor according to the shape of the parameter tensor of the parent node.

Accordingly, an inventive encoder, e.g. 200, 300, 300b and/or 400 for example node information unit 210 and/or PUT unit 310, 310b, 410, may optionally be configured to provide the update tensor such that a shape of the update tensor is different from a shape of the parameter tensor of the parent node.

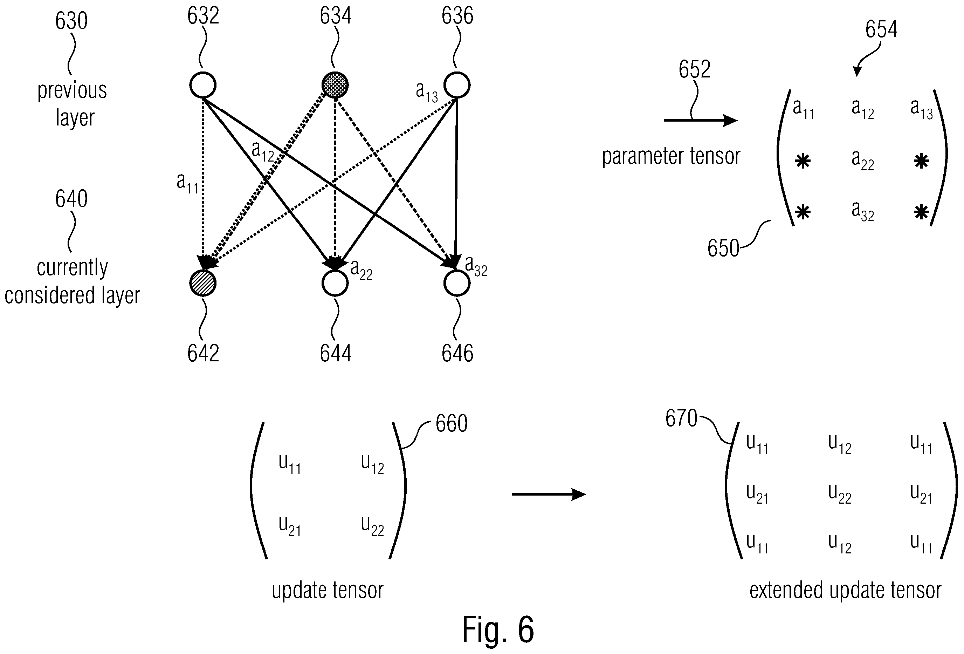

For further explanation, reference is made to Fig. 6. Fig. 6 shows a schematic example of a tensor shape conversion according to embodiments of the invention. Fig. 6 shows an example of a currently considered layer 630 of neurons of a neural network and of a previous layer 640 of the neural network.

As an example, tensor 650, may comprise neural network parameters, e.g. weights, associated with a parent node of the currently considered node, wherein tensor elements, e.g. a₁₁, a₁₂, a₁₃, of the parameter tensor 650 arranged along a first direction (e.g. along a row 652 of the tensor) may be associated with contributions of output signals of a plurality of neurons 632, 634, 636 of a previous layer 630 of the neural network to an input signal of a given neuron, e.g. 642, of a currently considered layer 640 of the neural network, and tensor elements, e.g. a₁₂, a₂₂, a₃₂, of the parameter tensor arranged along a second direction (e.g. along a column 654 of the tensor) are associated with contributions of an output signal of a given neuron, e.g. 634, of a previous layer 630 of the neural network to input signals of a plurality of neurons 642, 644, 646 of a currently considered layer 640 of the neural network. In the example of Fig. 6 for brevity not all weights between layers are shown (placeholders *).

Optionally, an inventive decoder, e.g. 100, 100b, e.g. deriving unit 130, 130b or obtaining unit 110, 110b, may optionally be configured to extend a dimension an update tensor 660 in the first direction 652, if the extension or dimension of the update tensor in the first direction (e.g. a row direction) is smaller than a dimension of the parameter tensor 650 in the first direction. Alternatively or in addition, the decoder may be configured to extend a dimension of the update tensor 660 in the second direction 654, if the extension or dimension of the update tensor in the second direction (e.g. a column direction) is smaller than a dimension of the parameter tensor 650 in the second direction.

Hence, an extended update tensor 670 may be provided, such that extended update tensor 670 may be combined with parameter tensor 650 in order to modify neural network parameters of the parent node to determine neural network parameters of a current node.

In general, it is to be noted that nodes and corresponding tensors may represent neural network parameters of a layer of a neural network, and/or of a whole neural network and hence of multiple layers.

Accordingly, an inventive encoder, e.g. 200, 300, 300b and/or 400 for example node information unit 210 and/or PUT unit 310, 310b, 410, may optionally be configured to provide the update tensor 660, such that the extension or dimension of the update tensor 660 in the first direction 652 (e.g. a row direction) is smaller than a dimension or extension of the parameter tensor 650 in the first direction. Alternatively or in addition, the encoder may be configured to provide the update tensor 660 such that the extension or dimension of the update tensor in the second direction 654 (e.g. a column direction) is smaller than a dimension or extension of the parameter tensor 650 in the second direction.

As shown in Fig 6, an update tensor 660 may, for example, comprise the change values u₁₁, u₁₂, u₂₁ and u₂₂. As shown with extended update tensor 670, optionally, an inventive decoder, e.g. 100, 100b, e.g. deriving unit 130, 130b, may optionally be configured to copy entries of a row of the update tensor 660, to obtain entries of one or more extension rows of a shape-converted update tensor 670, if a number or rows of the update tensor 660 is smaller than a number of rows of the parameter tensor 650.

Alternatively or in addition, the decoder may be configured to copy entries of a column of the update tensor 660, to obtain entries of one or more extension columns of a shape-converted update tensor 670, if a number or columns of the update tensor is smaller than a number of columns of the parameter tensor 650.

As shown in Fig. 6, e.g. as a simplified example, a first row of update tensor 660 may be duplicated to provide a third row of the extended update tensor 670 and a first column of update tensor 660 may be duplicated to provide a third column of the extended update tensor 670.

As optionally, shown an inventive decoder, e.g. 100, e.g. deriving unit 130, 130b, may optionally be configured to copy one or more entries of an update tensor in a row direction and in a column direction, to obtain entries of a shape-converted update tensor 670.

However, it is to be noted that only a row or a column may be copied or that only certain entries of a row and/or a column may be copied.

Accordingly, an inventive encoder, e.g. 200, 300, 300b and/or 400 for example node information unit 210 and/or PUT unit 310, 310b, 410, may optionally be configured to provide the update tensor 660 such that a number of rows of the update tensor is smaller than a number of rows of the parameter tensor 650. Alternatively, or in addition, the encoder may be configured to provide the update tensor 660 such that a number of columns of the update tensor is smaller than a number of columns of the parameter tensor 650.

As another optional feature, an inventive encoder, e.g. 200, 300, 300b and/or 400 for example node information unit 210 and/or PUT unit 310, 310b, 410, may optionally be configured to provide an information about an extension of the update tensor. This information may, for example additionally encoded in a bitstream, e.g. 202, 302 and/or 402. An inventive node information 112, 112b, 212, 312, 312b and/or 412 may optionally comprise such an extension information.

Accordingly, an inventive decoder, e.g. 100, 100b, e.g. deriving unit 130, 130b, may optionally be configured to determine a need to convert the shape of the update tensor, and/or an extent of a conversion of the shape of the update tensor, in dependence on an information about an extension of the update tensor.

As another optional feature, an inventive decoder, e.g. 100, 100b, e.g. obtaining unit 110, 110b, may optionally be configured to determine whether a parent node identifier information, e.g. 114, is present, e.g. in an encoded bitstream 102, and the decoder may be configured to derive one or more neural network parameters, e.g. 104, 104b, according to any embodiment as disclosed herein, if the parent node identifier is present, and furthermore, the decoder may be configured to make the currently considered node the root node if the parent node identifier is not present.

Hence, referring to Fig. 1 and Fig. 1b the parent node identifier information 114 (or respectively the generalized node information 112b) may comprise the information whether a parent node identifier is present or is not present, e.g. instead of or in addition to a parent node identifier (e.g. if present), such that a parameter update tree, for example set up and stored by PUT information unit 120, 120b may be adapted accordingly. This may allow to discard portions of a PUT that may not be needed any more, e.g. because corresponding parameter sets may be outdated or inferior to (e.g. worse than) newer parameter sets. Hence, in simple words, an upper part of a PUT may be discarded, such that the new root node of PUT is the currently considered node. On the other hand, this way a new PUT may be set up, starting from the currently considered node.

Accordingly, an inventive encoder, e.g. 200, 300, 300b and/or 400 for example node information unit 210 and/or PUT unit 310, 310b, 410, may optionally be configured to provide a signaling, comprising an information whether a parent node identifier is present or not. Hence, referring to Figs. 2 to 4, instead of the parent node identifier information 214, 314 and/or 414 may comprise such a signaling, e.g. instead of a parent node identifier, or in addition to a parent node identifier.

As another optional feature, the nodes of a PUT, e.g. nodes R, U0, to U9, 510 to 620, may be associated with a respective hash value. An inventive decoder, e.g. 100, 100b, e.g. PUT information unit 120, 120b, may optionally be configured to compare the parent node identifier (wherein the parent node identifier information 114 (or respectively the generalized node information 112b) may comprise the parent node identifier) with hash values associated with one or more nodes, to identify the parent node of the currently considered node.

Accordingly, an inventive encoder, e.g. 200, 300, 300b and/or 400 for example node information unit 210 and/or PUT unit 310, 310b, 410, may optionally be configured provide a hash value associated with a node as the parent node identifier (e.g. within the parent node identifier information 214, 314 and/or 414 or respectively the generalized node information 112b, 312b, for example encoded in the bitstream 202, 302, 302b and/or 402), to identify the parent node of the currently considered node.

Optionally, the hash values may be hash values of a full compressed data unit NDU associated with one or more previously decoded nodes.

As another optional feature, the hash value may be a hash value of a payload portion of a compressed data unit associated with one or more previously encoded nodes, while leaving a data size information and a header information unconsidered.

As another optional feature, the parent node identifier may be a combined value representing a device identifier and a serial number of which both are associated with the parent node.

As another optional feature, parent node identifier may identify an update tree, e.g. 500, and/or a layer of the neural net. A PUT may, for example, represent a portion of neural network parameters of a neural network. Hence, for a neural network a plurality of update trees may be set up, such that a differentiation in between trees may be advantageous. As an example, a PUT may represent one layer of a neural network.

As another optional feature, the node information, e.g. 112, 112b, 212, 312, 312b and/or 412 may comprise a node identifier. An inventive decoder, e.g. 100, 100b, e.g. PUT information unit 120, 120b, may optionally be configured to store the node identifier. Accordingly, an inventive encoder, e.g. 200, 300, 300b and/or 400 for example node information unit 210 and/or PUT unit 310, 310b, 410, may optionally be configured to store and/or to provide the node identifier.

As another optional feature, an inventive decoder, e.g. 100, 100b, e.g. PUT information unit 120, 120b, may optionally be configured to compare one or more stored node identifiers with a parent node identifier in a node information of a new node when adding the new node, in order to identify a parent node of the new node.

Accordingly, an inventive encoder, e.g. 200, 300, 300b and/or 400 for example node information unit 210 and/or PUT unit 310, 310b, 410, may optionally be configured to compare one or more stored node identifiers with a parent node identifier in a node information of a new node when adding the new node, in order to identify a parent node of the new node.

As another optional feature, the node identifier may identify an update tree, e.g. 500, to which the node information, e.g. 112, 112b, 212, 312, 312b and/or 412 is associated and/or a layer of the neural net to which the node information relates. Neural networks may comprise millions of parameters, hence only a selection of parameters may be organized in one single parameter tree. Furthermore, a searching time for an encoder or decoder may be reduced using an information about with which neural network layer, neural network parameters to be searched for, e.g. as parameters associated with a parent node, are associated.

As another optional feature, the node identifier, e.g. within node identifier information 114, 214, 314, 414 and respectively generalized node information 112b, 312b, may comprise a device identifier and/or a parameter update tree depth information and/or a parameter update tree identifier. One neural network may be trained on different devices, such that different sets of parameters may be available and for example even different iterations of such sets of parameters. Hence, an information about a device identifier, may allow to indicate a specific set of neural network parameters efficiently. A PUT depth information may reduce a time needed, for example, to find a corresponding parent node, in order to determine neural network parameters of a currently considered node, since it may not be necessary to search through all layers of the PUT.

As another optional feature, the node information, e.g. 112, 112b, 212, 312, 312b and/or 412, may comprise a signaling indicating whether a node identifier is present or not.

As another optional feature, the parent node identifier (e.g. within the parent node identifier information 114, 214, 314 and/or 414 and respectively generalized node information 112b, 312b, for example encoded in the bitstream 202, 302 and/or 402) is a combined value representing a device identifier and a serial number which both are associated with the parent node.

As another optional feature, the parent node identifier information 114, 214, 314 and/or 414 and respectively generalized node information 112b, 312b, may optionally comprise an information about the type of the parent node identifier. Hence, an inventive decoder, e.g. 100, 100b, e.g. obtaining unit 110, 110b, may optionally be configured to obtain a signaling, comprising an information about the type of the parent node identifier, and the decoder may be configured to evaluate the signaling in order to consider the respective type of the parent node identifier.

Accordingly, an inventive encoder, e.g. 200, 300, 300b and/or 400 for example node information unit 210 and/or PUT unit 310, 310b, 410, may optionally be configured to provide a signaling, comprising an information about the type of the parent node identifier.

As another optional feature, an inventive decoder, e.g. 100, 100b, e.g. PUT information unit 120, 120b, may optionally be configured to selectively evaluate a syntax element which indicates a type of the parent node identifier, in dependence on a syntax element indicating the presence of the parent node identifier.

Accordingly, an inventive encoder, e.g. 200, 300, 300b and/or 400 for example node information unit 210 and/or PUT unit 310, 310b, 410, may optionally be configured to selectively provide a syntax element which indicates a type of the parent node identifier, if a syntax element describing the parent node identifier is present.

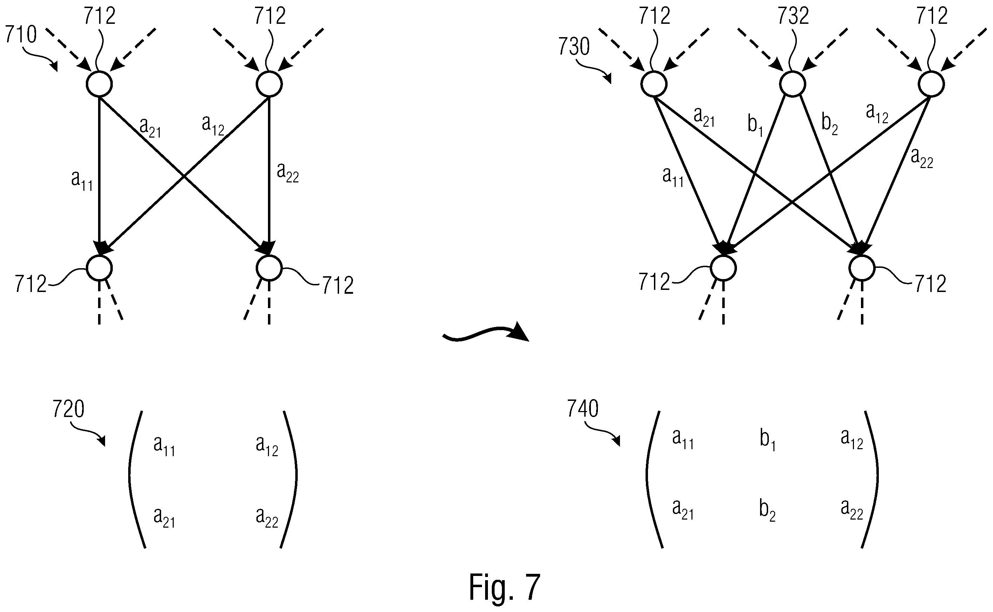

Fig. 7 shows an example for a topology change of a neural network according to embodiments of the invention. Fig. 7 shows a first topology 710 of a neural network section with neurons 712, wherein neural network parameters a₁₁, a₁₂, a₂₁ and a₂₂, e.g. weights, may be represented by a parameter tensor 720. As an example, the topology of the neural network section may change to a second topology 730 with a new node 732 and additional parameters b₁ and b₂. The neural network parameters of the neural network with topology 730 may be represented by tensor 740.

As an optional feature, an inventive decoder, e.g. 100, 100b, e.g. obtaining unit 110, 110b, may optionally be configured, to obtain a topology change signaling within the node information, comprising an information about a topology change of the neural network. As an example, the parent node identifier information, e.g. 114, may optionally, comprise the topology change signaling. Furthermore, the decoder may be configured to modify the parameter information of the parent node according to the topology change in order to derive one or more neural network parameters, e.g. as represented by tensor 740, of the neural network with modified topology.

Accordingly, an inventive encoder, e.g. 200, 300, 300b and/or 400 for example node information unit 210 and/or PUT unit 310, 310b, 410, may optionally be configured, to provide a topology change signaling within the node information, e.g. within the parent node identifier information 214, 314 and/or 414, comprising an information about a topology change of the neural network.

As another optional feature, an inventive decoder, e.g. 100, 100b, e.g. the PUT information unit 120, 120b and/or the e.g. deriving unit 130, 130b, may optionally be configured to change a shape of one or two tensors in response to a topology change information. As an example a tensor comprising change values may be adapted to a new shape of a parent node according to the new neural network topology.

Accordingly, an inventive encoder, e.g. 200, 300, 300b and/or 400 for example node information unit 210 and/or PUT unit 310, 310b, 410, may optionally be configured to signal a change a shape of one or two tensors, together with a signaling of a topology change.

As another optional feature, an inventive decoder, e.g. 100, 100b, e.g. PUT information unit 120, 120b, may optionally be configured to change a number of neurons of the given layer in response to the topology change information. As an example, a decoder on a device running the neural network may receive the topology change information and may hence adapt the structure of the neural network, e.g. in addition to adapting neural network parameters, e.g. weight values.

Accordingly, an inventive encoder, e.g. 200, 300, 300b and/or 400 for example node information unit 210 and/or PUT unit 310, 310b, 410, may optionally be configured to signal a change of a number of neurons of the given layer using the topology change information. Such topology change information may be included in a generalized node information, e.g. 312 b.

As another optional feature, an inventive decoder, e.g. 100, 100b, e.g. PUT information unit 120, 120b and/or e.g. deriving unit 130, 130b, may optionally be configured to replace one or more tensor values of one or more tensors, a shape of which is to be changed, associated with a parent node of the currently considered node with one or more replacement values, in order to obtain one or more tensors having a modified size, or the decoder may be configured to replace one or more tensors, a shape of which is to be changed, associated with a parent node of the currently considered node with one or more replacement tensors, in order to obtain one or more tensors having a modified size.

Accordingly, an inventive encoder, e.g. 200, 300, 300b and/or 400 for example node information unit 210 and/or PUT unit 310, 310b, 410, may optionally be configured to signal a replacement of one or more tensor values of one or more tensors, a shape of which is to be changed, associated with a parent node of the currently considered node with one or more replacement values, or the encoder may be configured to signal a replacement of one or more tensors, a shape of which is to be changed, associated with a parent node of the currently considered node with one or more replacement tensors.

As another optional feature, an inventive decoder, e.g. 100, 100b, e.g. deriving unit 130, 130b, may optionally be configured to change shapes of two tensors in two update trees associated with neighboring layers of the neural net in a synchronized manner, in response to the topology change signaling.

Accordingly, an inventive encoder, e.g. 200, 300, 300b and/or 400 for example node information unit 210 and/or PUT unit 310, 310b, 410, may optionally be configured to signal a change of shapes of two tensors in two update trees associated with neighboring layers of the neural net in a synchronized manner, using the topology change signaling.

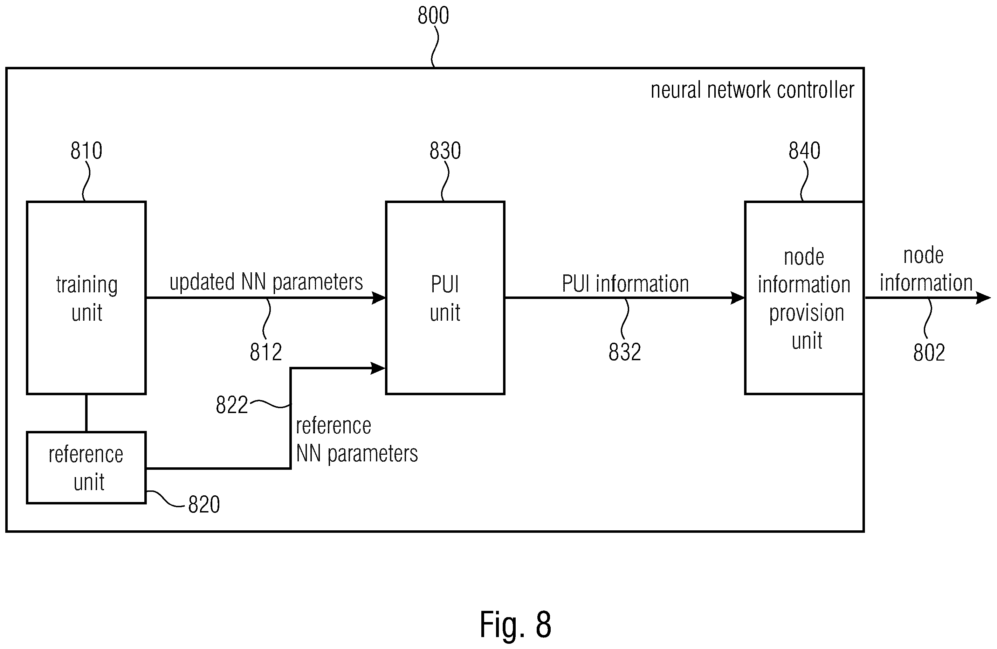

Fig. 8 shows a schematic view of a neural network controller according to embodiments of the invention. Fig. 8 shows a neural network controller 800 comprising a training unit 810, a reference unit 820, a parameter update information, PUI, unit 830 and a node information provision unit 840.

The training unit 810 may be configured to train a neural network, to obtain updated neural network parameters 812 on the basis of initial neural network parameters. As an example, the initial neural network parameters may be default parameters or for example a first set of neural network parameters, starting from which, the neural network may be trained. As an optional feature, the initial neural network parameters may be provided to the training unit 810 using or by the reference unit 820. The initial neural network parameters may be stored in the reference unit 820 or may, for example, initially provided to the neural network controller 800.

As an example, based on the updated neural network parameters a second training may be performed. Hence, the updated neural network parameters may, for example be reference or starting parameters for a second training. Such reference parameters may be stored in the reference unit 820. Therefore, in a first step, reference parameters, e.g. the parameters based on which a training is performed, may be equal to initial neural network parameters.

Furthermore, the PUI unit 830 may be configured to determine a parameter update information, PUI, 832 on the basis of the reference neural network parameters 822 and the updated neural network parameters 812. Therefore, reference unit 820 may provide the reference neural network parameters 822, e.g. the parameters based on which a training was performed in order to obtain the updated neural network, NN, parameters, to the PUI unit 830.

The PUI 832 may, for example, as well comprises one or more update instructions describing how to derive the updated neural network parameters, at least approximately, from the initial neural network parameters.

The reference NN parameters 882 may, for example, be the initial neural network parameters (e.g. even in a second, third, fourth or further training step), such that the parameter update information 832 may comprise an information on how to modify the initial neural network parameters in order to calculate or determine the updated NN parameters 812.

However, such an information may as well be included in the PUI 832, for a recursive reconstruction. Hence, an information on how to modify reference NN parameters 822, e.g. starting parameters for one training cycle, in order to obtain the updated NN parameters 812, that are different form the initial NN parameters, may be included in the PUI.

Referring to Fig. 5, the PUI may hence comprise an information on a whole path from root node R, 510, associated with initial neural network parameters, e.g. 512, to a currently considered node, e.g. U3, 550, associated with the updated NN parameters, e.g. 552, or just about a section of such a path, e.g. via one or more nodes, e.g. from U2, 520, associated with reference parameters, e.g. 522, to node U4, associated with updated NN parameters, e.g. 562. Here it is again to be noted that - in simple words - in between the reference NN parameters 822 and the updated NN parameters one or more trainings and hence one or more parameter updates may be performed.

To put it in other words, the PUI information may optionally comprise an information on how to modify reference NN parameters 822, being an initial or arbitrary or intermediate starting point for a NN training, in order to obtain the updated NN parameters 812.

Furthermore, the node information provision unit 840 may be configured to provide a node information 802 comprising a parent node identifier information(e.g. as explained before) and the parameter update information PUI (e.g. as explained before), wherein the parent node identifier defines a parent note, parameter information of which serves as a starting point for the application of the parameter update information.

Hence, the parent node identifier, may be used to provide a reference information for the PUI information, in order to identify reference NN parameters 822 that are to be modified by the PUI information in order to obtain the updated NN parameters 832

As another optional feature, the neural network controller 800 may comprise an encoder according to any of the embodiments as disclosed herein and/or any functionality, or combination of functionalities, of any inventive encoder as disclosed herein.

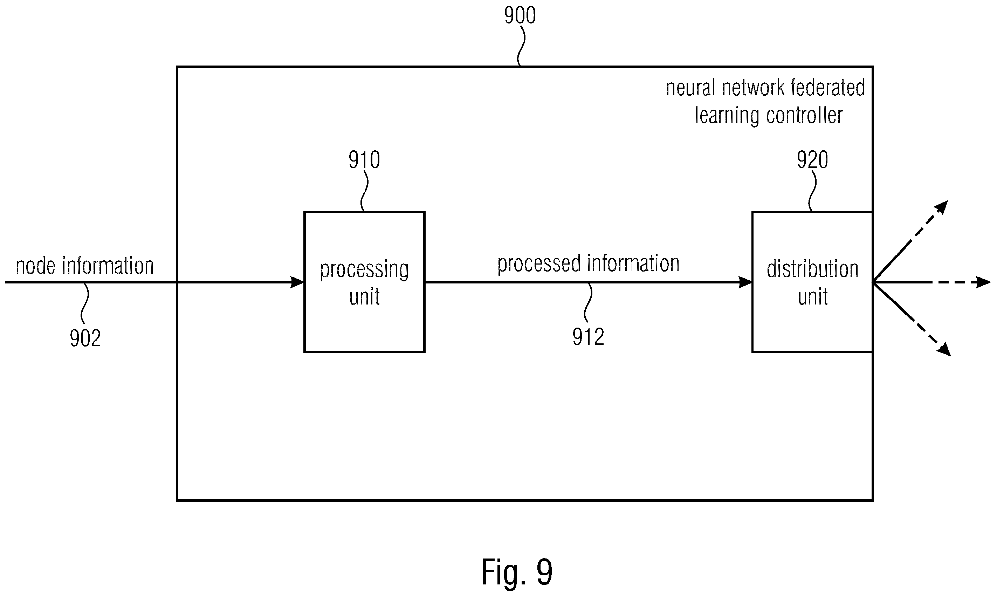

Fig. 9 shows a schematic view of a neural network federated learning controller according to embodiments of the invention. Fig. 9 shows neural network federated learning controller 900 comprising a processing unit 910 and a distribution unit 920.

The neural network federated learning controller 900 is configured to receive a node information 902 of a plurality of neural networks, wherein the node information comprises a parent node identifier (or for example a parent node identifier information comprising the parent node identifier) and a parameter update information.

Furthermore, processing unit 910 is configured to combine parameter update information of several corresponding nodes of different neural networks, to obtain a combined parameter update information. Processed information 912 may comprise or may be the combined parameter update information.

Moreover, distributing unit 920 is configured to distribute the processed information, e.g. the combined parameter update information.

Hence, the neural network federated learning controller 900 may operate as a coordination unit in order to combine several training results (e.g. the parameter update information) of several corresponding nodes of different neural networks. Therefore robust neural network parameters may be extracted and provided in the form of the processed information.

As an optional feature, the neural network federated learning controller 900, e.g. processing unit 910, may be configured to combine parameter update information of several corresponding nodes having equal parent node identifiers of different neural networks, to obtain a combined parameter update information. Hence, processed information 912 may comprise or may be the combined parameter update information.

Therefore, as an example, NN training results based on equal starting parameters may be combined, in order to provide a robust set of NN parameters.

As an optional feature, the neural network federated learning controller 900, e.g. distribution unit 920 may be configured to distribute parameter information of a parent node, to which the parent node identifier is associated, to a plurality of decoders and the neural network federated learning controller 900, e.g. processing unit 912, may be configured to receive from the decoders node information comprising the parent node identifier. Furthermore, the neural network federated learning controller 900, e.g. processing unit 910, is configured to combine parameter update information of several corresponding nodes having the parent node identifier.

As another optional feature, the neural network federated learning controller 900, e.g. distribution unit 920, may, for example, be configured to provide a node information, e.g. within or being the processed information 912, describing a combined node information of a parameter update tree, wherein the combined node information comprises the parent node identifier, and wherein the combined node information comprises the combined parameter update information.

As another optional feature, the neural network federated learning controller 900 may optionally comprise an encoder according to any embodiments disclosed herein or the neural network federated learning controller 900 may optionally comprise any functionality, or combination of functionalities, of an inventive encoder as disclosed herein.

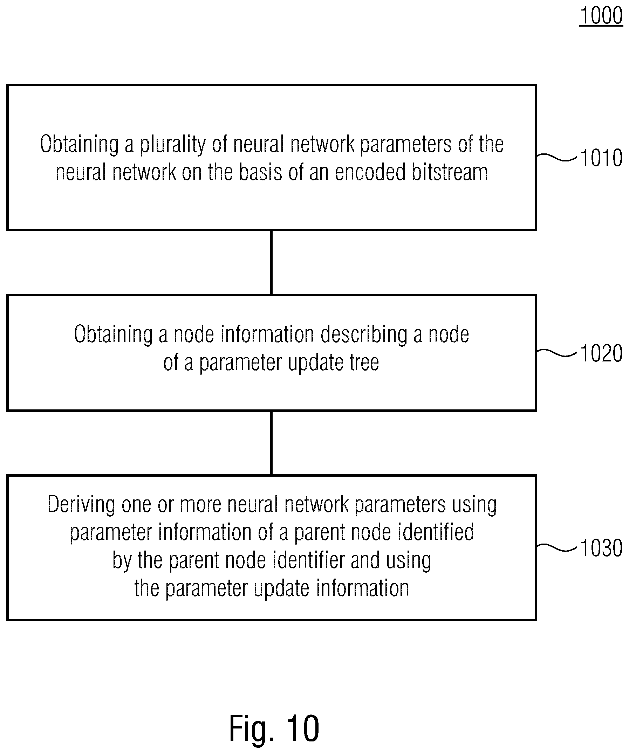

Fig. 10 shows a schematic block diagram of a method for decoding parameters of a neural network according to embodiments of the invention. Method 1000 comprises obtaining 1010 a plurality of neural network parameters of the neural network on the basis of an encoded bitstream, obtaining 1020 a node information describing a node of a parameter update tree, wherein the node information comprises a parent node identifier, and wherein the node information comprises a parameter update information, and deriving 1030 one or more neural network parameters using parameter information of a parent node identified by the parent node identifier and using the parameter update information.

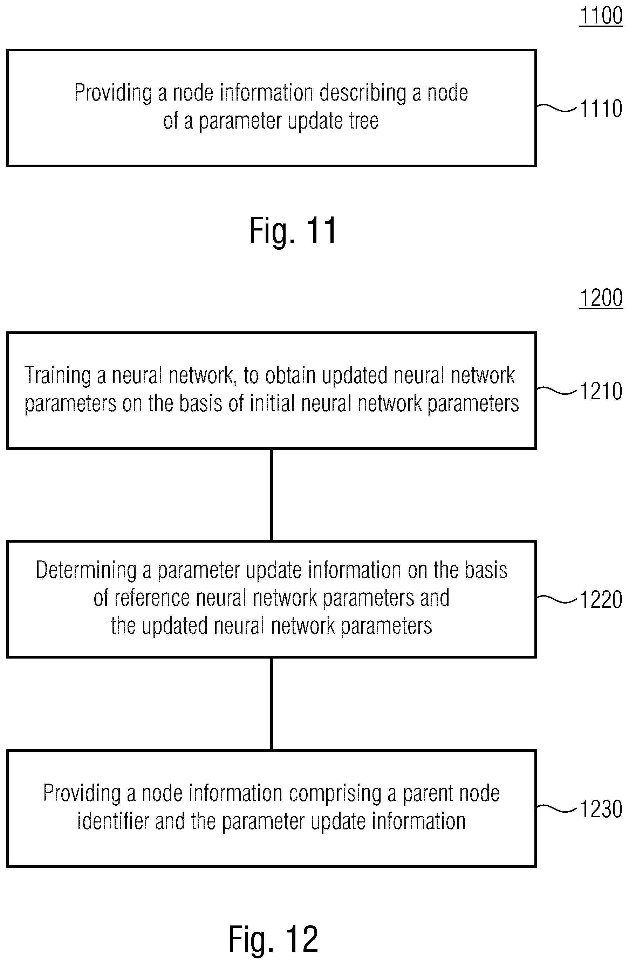

Fig. 11 shows a schematic block diagram of a method for encoding parameters of a neural network in order to obtain an encoded bitstream according to embodiments of the invention. Fig. 11 shows method 1100 comprising providing 1110 a node information describing a node of a parameter update tree, wherein the node information comprises a parent node identifier, and wherein the node information comprises a parameter update information; wherein the parameter update information describes differences between neural network parameters associated with a parent node defined by the parent node identifier and current neural network parameters.

Fig. 12 shows a schematic block diagram of a method for controlling a neural network according to embodiments of the invention. Fig. 12 shows method 1200 comprising training 1210 a neural network, to obtain updated neural network parameters on the basis of initial neural network parameters, and determining 1220 a parameter update information on the basis of reference neural network parameters and the updated neural network parameters, wherein the parameter update information comprises one or more update instructions describing how to derive the updated neural network parameters, at least approximately, from the initial neural network parameters, and providing 1230 a node information comprising a parent node identifier and the parameter update information, wherein the parent node identifier defines a parent note, parameter information of which serves as a starting point for the application of the parameter update information.

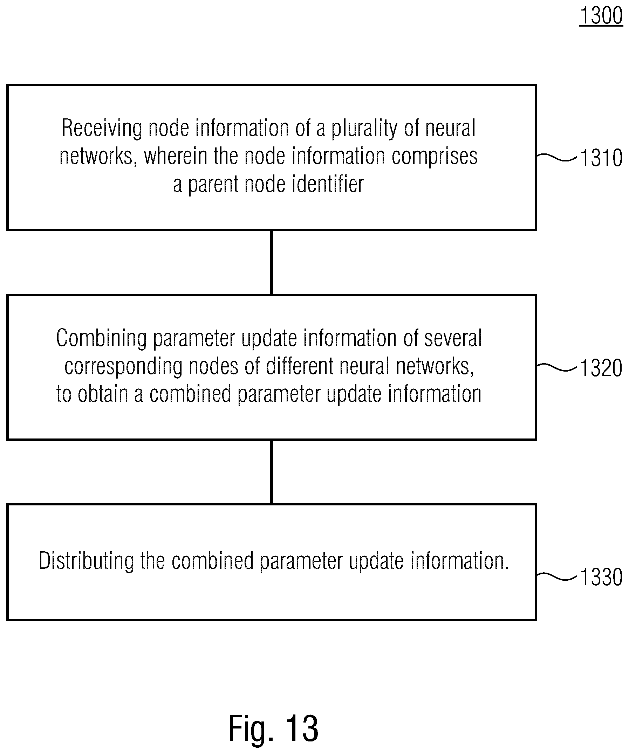

Fig. 13 shows a schematic block diagram of a method for controlling neural network federated learning according to embodiments of the invention. Fig. 13 shows method 1300 comprising receiving 1310 node information of a plurality of neural networks, wherein the node information comprises a parent node identifier, and wherein the node information comprises a parameter update information. The method further comprises combining 1320 parameter update information of several corresponding nodes of different neural networks, to obtain a combined parameter update information, and distributing 1330 the combined parameter update information.

Further embodiments according to the invention are related to, or may be used for, or may address HLS (e.g. HTTP (e.g. Hypertext Transfer Protocol) live streaming) update signaling.

Furthermore, it is to be noted that embodiments can be applied to the compression of entire neural networks, and some of them can also be applied to the compression of differential updates of neural networks with respect to a base network. Such differential updates are for example useful when models are redistributed after fine-tuning or transfer learning, or when providing versions of a neural network with different compression ratios.

Embodiments may further address usage, e.g. manipulation or modification of base neural network, e g. neural network serving as reference for a differential update.

Embodiments may further address or comprise or provide updated neural network, e.g. neural network resulting from modifying the base neural network. Note: The updated neural network may, for example, be reconstructed by applying a differential update to the base neural network.

Further embodiments according to the invention may comprise syntax elements in the form of NNR units. A NNR unit may, for example be a data structure for carrying neural network data and/or related metadata which may be compressed or represented, e.g. according to embodiments of the invention.

NNR units may carry at least one of a compressed information about neural network metadata, uncompressed information about neural network metadata, topology information, complete or partial layer data, filters, kernels, biases, quantized weights, tensors and alike.

An NNR unit may, for example comprise, or consist of the following data elements
- NNR unit size (optional): This data element may signal the total byte size of the NNR Unit, including the NNR unit size.
- NNR unit header: This data element may comprise or contain information about the NNR unit type and/or related metadata.
- NNR unit payload: This data element may comprise or contain compressed or uncompressed data related to the neural network.

As an example, embodiments may comprise (or use) the following bitstream syntax:

| | |
|---|---|
| nnr_unit( numBytesInNNRUnit ) { | **Descriptor** |
| nnr_unit_size( ) (optional) | |
| nnr_unit_header( ) | |
| nnr_unit_payload( ) | |
| } | |

| | |
|---|---|
| nnr_unit_header( ) { | **Descriptor** |
| **nnr_unit_type** | u(6) |
| **nnr_compressed_data_unit_payload_type** | u(5) |
| ⋮ | |
| further optional configuration information | |
| ⋮ | |
| if( nnr_unit_type == NNR_NDU ) | |
| nnr_compressed_data_unit_header( ) | |
| ⋮ | |
| further optional configuration information | |
| ⋮ | |
| } | |
| nnr_compressed_data_unit_header( ) { | **Descriptor** |
| **nnr_compressed_data_unit_payload_type** | u(5) |
| ⋮ | |
| Further optional configuration information | |
| ⋮ | |
| **node_id_present_flag** | u(1) |
| if( node_id_present_flag ) { | |
| **device_id** | ue(1) |
| **parameter_id** | ue(5) |
| **put_node_depth** | ue(4) |
| } | |
| **parent_node_id_present_flag** | u(1) |
| if( parent_node_id_present_flag ) { | |
| **parent_node_id_type** | u(2) |
| **temporal_context_modeling_flag** | u(1) |
| if( parent_node_id_type == ICNN_NDU_ID ) { | |
| **parent_device_id** | ue(1) |
| if( !node_id_present_flag ) { | |
| **parameter_id** | ue(5) |
| **put_node_depth** | ue(4) |
| } | |
| } else if( parent_node_id_type == ICNN_NDU_PL_SHA256 ) | |
| **parent_node_payload_sha256** | u(256) |
| else | |
| **parent_node_payload_sha512** | u(512) |
| } | |
| ⋮ | |
| further optional configuration information | |
| ⋮ | |
| } | |

The parent node identifier, may for example comprise one or more of the above syntax elements, to name some, e.g. device_id, parameter_id and/or put_node_depth.

| | |
|---|---|
| nnr_unit_payload( ) { | **Descriptor** |
| ⋮ | |
| further optional configuration information | |
| ⋮ | |
| if( nnr_unit_type == NNR_NDU ) | |
| nnr_compressed_data_unit_payload( ) | |
| ⋮ | |
| further optional configuration information | |
| ⋮ | |
| } | |

| | |
|---|---|
| nnr_compressed_data_unit_payload( ) { | **Descriptor** |
| if( nnr_compressed_data_unit_payload_type == NNR_PT_ RAW_FLOAT) | |
| for( i = 0; i < Prod( TensorDimensions ); i++ ) | |
| **raw_float32_parameter**[ TensorIndex( TensorDimensions, i, 0 ) ] | flt(32) |
| decode_compressed_data_unit_payload( ) | |
| } | |

Using the decode_compressed_data_unit_payload() parameters of a base model of the neural network may be modified in order to obtain an updated model. Hence, using the above nnr_compressed_data_unit_payload() one or more neural network parameters using parameter information of a parent node identified by the parent node identifier and using the parameter update information may be derived.

**node_id_present_flag** equal to 1 may indicate that syntax elements device_id, parameter_id, and/or put_node_depth are present.

**device_id** may, for example, uniquely identify the device that generated the current NDU.

**parameter_id** may, for example, uniquely identify the parameter of the model to which the tensors stored in the NDU relate to. If parent_node_id_type is equal to ICNN_NDU_ID, parameter_id may, for example, or shall equal the parameter_id of the associated parent NDU.

**put_node_depth** may, for example, be the tree depth at which the current NDU is located. A depth of 0 may correspond to the root node. If parent_node_id_type is equal to ICNN_NDU_ID, put_node_depth - 1 may, for example, be or even must equal the put_node_depth of the associated parent NDU.

**parent_node_id_present_flag** equal to 1 may, for example, indicate that syntax element parent_node_id_type is present.

**parent_node_id_type** may, for example, specify the parent node id type. It may indicate which further syntax elements for uniquely identifying the parent node are present. Examples for the allowed values for parent_node_id_type are defined in Table 1

**Table 1: Parent node id type identifiers (example).**

| **parent_node_id_type** | **Identifier** | **Description** |
|---|---|---|
| 0 | ICNN_NDU_ID | Indicates that syntax elements parent_device_id, parameter_id, and put_node_depth are present |
| 1 | ICNN_NDU_PL_SHA256 | Indicates that syntax element parent_node_payload_sha256 is present |
| 2 | ICNN_NDU_PL_SHA512 | Indicates that syntax element parent_node_payload_sha512 is present |
| 3 | | Reserved |

**temporal_context_modeling_flag** may, for example, specify whether temporal context modeling is enabled. A temporal_context_modeling_flag equal to 1 may indicate that temporal context modeling is enabled. If temporal_context_modeling_flag is not present, it is inferred to be 0.

**parent_device_id** may, for example, be equal to syntax element device_id of the parent NDU.

**parent_node_payload_sha256** may, for example, be a SHA256 hash of the nnr_compressed_data_unit_payload of the parent NDU.

**parent_node_payload_sha512** may, for example, be a SHA512 hash of the nnr_compressed_data_unit_payload of the parent NDU.

Furthermore, embodiments according to the invention may comprise a row skipping feature. As an example, if enabled by flag row_skip_flag_enabled_flag, the row skipping technique signals one flag row_skip_list[ i ] for each value i along the first axis of the parameter tensor. If the flag row_skip_list[ i ] is 1, all elements of the parameter tensor for which the index for the first axis equals i are set to zero. If the flag row_skip_list[ i ] is 0, all elements of the parameter tensor for which the index for the first axis equals i are encoded individually.

Furthermore, embodiments according to the invention may comprise a context modelling. As an example, context modelling may correspond to associating the three type of flags sig_flag, sign_flag, and abs_level_greater_x/x2 with context models. In this way, flags with similar statistical behavior may be or should be associated with the same context model so that the probability estimator (inside of the context model) can, for example, adapt to the underlying statistics.

The context modelling of the presented approach may, for example, be as follows:
For example, twenty-four context models may be distinguished for the sig_flag, depending on the state value and whether the neighbouring quantized parameter level to the left is zero, smaller, or larger than zero.

If dq_flag is 0, only the first three context models may, for example, be used.

Three other context models may, for example, be distinguished for the sign_flag depending on whether the neighbouring quantized parameter level to the left is zero, smaller, or larger than zero.

For the abs_level_greater_x/x2 flags, each x may, for example, be use either one or two separate context models. If x <= maxNumNoRemMinus1, two context models are distinguished depending on the sign_flag. If x > maxNumNoRemMinus1, only one context model may, for example, be used.

Furthermore, embodiments according to the invention may comprise temporal context modelling. As an example, if enabled by flag temporal_context_modeling_flag, additional context model sets for flags sig_flag, sign_flag and abs_level_greater_x may be available. The derivation of ctxldx may then be also based on the value of a quantized co-located parameter level in the previously encoded parameter update tensor, which can, for example, be uniquely identified by the parameter update tree. If the co-located parameter level is not available or equal to zero, the context modeling, e.g. as explained before, may be applied. Otherwise, if the co-located parameter level is not equal to zero, the temporal context modeling of the presented approach may be as follows:
Sixteen context models may, for example, be distinguished for the sig_flag, depending on the state value and whether the absolute value of the quantized co-located parameter level is greater than one or not.

If dq_flag is 0, only the first two additional context models may be used.

Two more context models may, for example, be distinguished for the sign_flag depending on whether the quantized co-located parameter level is smaller or greater than zero.

For the abs_level_greater_x flags, each x may use two separate context models. These two context models may, for example, be distinguished depending on whether the absolute value of the quantized co-located parameter level is greater or equal to x-1 or not.

Embodiments according to the invention may optionally comprise the following tensor syntax, e.g. a quantized tensor syntax.

| | |
|---|---|
| quant_tensor( dimensions, maxNumNoRemMinus1, entryPointOffset ) { | **Descriptor** |
| tensor2DHeight = dimensions[ 0 ] | |
| tensor2DWidth = Prod( dimensions ) / tensor2DHeight | |
| if( general_profile_idc == 1 && tensor2DWidth > 1 ) { | |
| **row_skip_enabled_flag** | uae(1) |
| if( row_skip_enabled_flag ) | |
| for( i = 0; i < tensor2DHeight; i++ ) | |
| **row_skip_list**[ i ] (optional) | ae(v) |
| } | |
| stateld = 0 (optional) | |
| bitPointer = get_bit_pointer( ) (optional) | |
| lastOffset = 0 (optional) | |
| for( i = 0; i < Prod( dimensions ); i++ ) { | |
| idx = TensorIndex( dimensions, i, scan_order ) (optional) | |
| if( entryPointOffset != -1 && | |
| GetEntryPointIdx( dimensions, i, scan_order ) != -1 && | |
| scan_order > 0 ) { (optional) | |
| IviCurrRange = 256 (optional) | |
| j = entryPointOffset + | |
| GetEntryPointIdx( dimensions, i, scan_order ) (optional) | |
| IvlOffset = cabac_offset_list[ j ] (optional) | |
| if( dq_flag ) (optional) | |
| stateld = dq_state_list[ j ] (optional) | |
| set_bit_pointer( bitPointer + lastOffset + BitOffsetList[ j ] ) (optional) | |
| lastOffset = BitOffsetList[ j ] (optional) | |
| init_prob_est_param( ) (optional) | |
| } | |
| QuantParam[ idx ] = 0 | |
| if( general_profile_idc != 1 ∥ tensor2DWidth <= 1 ∥ | |
| !row_skip_enabled_flag ∥ | |
| !row_skip_list[ idx[ 0 ] ] ) | |
| int_param( idx, maxNumNoRemMinus1, stateId ) (optional) | e.g. as explained in the following |
| ⋮ | |
| further optional configuration information | |
| ⋮ | |
| } | |
| } | |

The skip information may, for example, comprise any or all of the above row skip information e.g. row_skip_enabled_flag and/or row_skip_list.

As an example, row_skip_enabled_flag may specify whether row skipping is enabled. A row_skip_enabled_flag equal to 1 may indicate that row skipping is enabled.

row_skip_list may specify a list of flags where the i-th flag row_skip_lsit[i] may indicate whether all tensor elements of QuantParam for which the index for the first dimension equals i are zero. If row_skip_list[i] is equal to 1, all tensor elements of QuantParam for which the index for the first dimension equals i may be zero.

Embodiments according to the invention may, for example, further comprise a quantized parameter syntax, as an example a syntax as defined in the following. All elements may be considered as optional.

| | |
|---|---|
| int_param( i, maxNumNoRemMinus1, stateId ) { | **Descriptor** |
| | |
| **sig_flag** | ae(v) |
| if( sig_flag ) { | |
| QuantParam[ i ]++ | |
| **sign_flag** | ae(v) |
| j = -1 | |
| do { | |
| j++ | |
| **abs_level_greater_x**[ j ] | ae(v) |
| QuantParam[ i ] += abs_level_greater_x[ j ] | |
| } while( abs_level_greater_x[ j ] == 1 && j < maxNumNoRemMinus1 ) | |
| if( abs_level_greater_x[ j ] == 1 ) { | |
| RemBits = 0 | |
| j = -1 | |
| do { | |
| j++ | |
| **abs_level_greater_x2**[ j ] | ae(v) |
| if( abs_level_greater_x2[ j ] ) { | |
| QuantParam[i] += 1 << RemBits | |
| RemBits++ | |
| } | |
| } while( abs_level_greater_x2[ j ] && j < 30 ) | |
| **abs_remainder** | uae(RemBits) |
| QuantParam[ i ] += abs_remainder | |
| } | |
| QuantParam[ i ] = sign_flag ? -QuantParam[ i ] : QuantParam[ i ] | |
| } | |
| } | |

sig_flag may, for example, specify whether the quantized weight QuantParam[i] is nonzero. A sig_flag equal to 0 may, for example, indicate that QuantParam[i] is zero. sign_flag may, for example, specify whether the quantized weight QuantParam[i] is positive or negative. A sign_flag equal to 1 may, for example, indicate that QuantParam[i] is negative. abs_level_greater_x[j] may, for example, indicate whether the absolute level of QuantParam[i] is greater j + 1.

abs_level_greater_x2[j] may, for example, comprise the unary part of the exponential Golomb remainder.

abs_remainder may, for example, indicate a fixed length remainder.

Further embodiments according to the invention may, for example, comprise the following shift parameter indices syntax. All elements may be considered as optional.

| | |
|---|---|
| shift_parameter_ids( maxNumNoRemMinus1 ) { | Descriptor |
| for( i = 0; i < (dq_flag ? 24 : 3; i++ ) { | |
| shift_idx( i, ShiftParameterIdsSigFlag ) | |
| } | |
| if(temporal_context_modeling_flag){ | |
| for( i = 24; i < (dq_flag ? 40 : 26); i++ ) { | |
| shift_idx( i, ShiftParameterIdsSignFlag ) | |
| } | |
| } | |
| for( i = 0; i < ( temporal_context_modeling_flag ? 5:3 ); i++ ) { | |
| shift_idx( i, ShiftParameterIdsSignFlag ) | |
| } | |
| for( i = 0; i < (temporal_context_modeling_flag ? 4 : 2)*(maxNumNoRemMinus1+1); i++ ) { | |
| shift_idx( i, ShiftParameterIdsAbsGrX ) | |
| } | |
| for( i = 0; i < 31; i++ ){ | |
| shift_idx( i, ShiftParameterIdsAbsGrX2 ) | |
| } | |
| } | |

Further embodiments according to the invention comprise entropy decoding processes, as explained in the following.

In general inputs to this process may, for example, be a request for a value of a syntax element and values of prior parsed syntax elements.

Output of this process may, for example be the value of the syntax element.

The parsing of syntax elements may, for example, proceed as follows:
For each requested value of a syntax element a binarization may, for example, bederived.

The binarization for the syntax element and the sequence of parsed bins may, for example, determine the decoding process flow.

Example for Initialization process:
In general, outputs of this process may, for example, be initialized DeepCABAC internal variables.

The context variables of the arithmetic decoding engine may, for example, be initialized as follows:
The decoding engine may, for example, register IvICurrRange and IvlOffset both in 16 bit register precision may, for example, be initialized by invoking the initialization process for the arithmetic decoding engine.

Embodiments according to the invention may comprise an initialization process for probability estimation parameters, e.g. as explained in the following.

Outputs of this process may, for example, be the initialized probability estimation parameters shift0, shift1, pStateldx0, and pStateldx1 for each context model of syntax elements sig_flag, sign_flag, abs_level_greater_x, and abs_level_greater_x2.

The 2D array CtxParameterList [][] may, for example, beinitialized as follows: 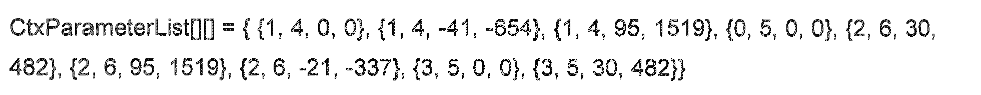 CtxParameterList[][] = { {1, 4, 0, 0}, {1, 4, -41, -654}, {1, 4, 95, 1519}, {0, 5, 0, 0}, {2, 6, 30, 482}, {2, 6, 95, 1519}, {2, 6, -21, -337}, {3, 5, 0, 0}, {3, 5, 30, 482}}

If dq_flag is equal to 1 and temporal_context_modeling_flag is equal to 1, for each of the e.g. 40 context models of syntax element sig_flag, the associated context parameter shift0 may, for example, beset to CtxParameterList[setld][0], shift1 may, for example, be set to CtxParameterList[setld][1], pStateldx0 may, for example, be set to CtxParameterList[setld][2], and pStateldx1 may, for example, be set to CtxParameterList[setld][3], where i may, for example, be the index of the context model and where setld may, for example, be equal to ShiftParameterldsSigFlag[i].

If dq_flag == is equal to 1 and temporal_context_modeling_flag is equal to 0, e.g. for each of the first e.g. 24 context models of syntax element sig_flag, the associated context parameter shift0 may, for example, be set to CtxParameterList[setld][0], shift1 may, for example, be set to CtxParameterList[setld][1], pStateldx0 may, for example, be set to CtxParameterList[setld][2], and pStateldx1 may, for example, be set to CtxParameterList[setld][3], where i may, for example, be the index of the context model and where setld may, for example, be equal to ShiftParameterldsSigFlag[i].

If dq_flag is equal to 0 and temporal_context_modeling_flag is equal to 1, e.g. for each of the e.g. first 3 context models and e.g. context models 24 to 25 of syntax element sig_flag, the associated context parameter shift0 may, for example, be set to CtxParameterList[setld][0], shift1 may, for example, be set to CtxParameterList[setld][1], pStateldx0 may, for example, be set to CtxParameterList[setld][2], and pStateldx1 may, for example, be set to CtxParameterList[setld][3], where i may, for example, be the index of the context model and where setld may, for example, be equal to ShiftParameterldsSigFlag [i].

If temporal_context_modeling_flag is equal to 1, e.g. for each of the for example 5 context models of syntax element sign_flag, the associated context parameter shift0 may, for example, be set to CtxParameterList[setld][0], shift1 may, for example, be set to CtxParameterList[setld][1], pStateldx0 may, for example, be set to CtxParameterList[setld][2], and pStateldx1 may, for example, be set to CtxParameterList[setld][3], where i may, for example, be the index of the context model and where setld may, for example, be equal to ShiftParameterldsSignFlag[i].

Otherwise, (temporal_context_modeling_flag == 0), e.g. for each of the first e.g. 3 context models of syntax element sign_flag, the associated context parameter shift0 may, for example, be set to CtxParameterList[setld][0], shift1 may, for example, be set to CtxParameterList[setld][1], pStateldx0 may, for example, be set to CtxParameterList[setld][2], and pStateldx1 may, for example, be set to CtxParameterList[setld][3], where i may, for example, be the index of the context model and where setld may, for example, be equal to ShiftParameterldsSignFlag[i].

If temporal_context_modeling_flag is equal to 1, e.g. for each of the 4 * (cabac_unary_length_minus1 + 1) context models of syntax element abs_level_greater_x, the associated context parameter shift0 may, for example, be set to CtxParameterList[setld][0], shift1 may, for example, be set to CtxParameterList[setld][1], pStateldx0 may, for example, be set to CtxParameterList[setld][2], and pStateldx1 may, for example, be set to CtxParameterList[setld][3], where i may, for example, be the index of the context model and where setld may, for example, be equal to ShiftParameterldsAbsGrX[i].

Otherwise, (temporal_context_modeling_flag == 0), e.g. for each of the first e.g. 2 * (cabac_unary_length_minus1 + 1) context models of syntax element abs_level_greater_x, the associated context parameter shift0 may, for example, be set to CtxParameterList[setld][0], shift1 may, for example, be set to CtxParameterList[setld][1], pStateldx0 may, for example, be set to CtxParameterList[setld][2], and pStateldx1 may, for example, be set to CtxParameterList[setId][3], where i may, for example, be the index of the context model and where setld may, for example, be equal to ShiftParameterldsAbsGrX[i].

Further embodiments according to the invention may comprise a decoding process flow, e.g. as explained in the following.

In general, inputs to this process may, for example, be all bin strings of the binarization of the requested syntax element.

Output of this process may, for example, be the value of the syntax element.

This process may specify how e.g. each bin of a bin string is parsed e.g. for each syntax element. After parsing e.g. each bin, the resulting bin string may, for example, be compared to e.g. all bin strings of the binarization of the syntax element and the following may apply:
- If the bin string is equal to one of the bin strings, the corresponding value of the syntax element may, for example, be the output.
- Otherwise (the bin string is not equal to one of the bin strings), the next bit may, for example, be parsed.

While parsing each bin, the variable binldx may, for example, be incremented by 1 starting with binldx being set equal to 0 for the first bin.

The parsing of each bin may, for example, be specified by the following two ordered steps:
1. A derivation process for ctxldx and bypassFlag as may, for example, be invoked e.g. with binldx as input and ctxldx and bypassFlag as outputs.
2. An arithmetic decoding process may, for example, be invoked with ctxldx and bypassFlag as inputs and the value of the bin as output.

Further embodiments according to the invention may comprise a derivation process of ctxlnc for the syntax element sig_flag.

Inputs to this process may, for example, be the sig_flag decoded before the current sig_flag, the state value stateld, the associated sign_flag, if present, and, if present, the co-located parameter level (coLocParam) from the incremental update decoded before the current incremental update. If no sig_flag was decoded before the current sig_flag, it may, for example, be inferred to be 0. If no sign_flag associated with the previously decoded sig_flag was decoded, it may, for example, be inferred to be 0. If no co-located parameter level from an incremental update decoded before the current incremental update is avaiable, it is inferred to be 0. A co-located parameter level means the parameter level in the same tensor at the same position in previously decoded incremental update.

Output of this process is the variable ctxInc.

The variable ctxlnc is derived as follows:
- If coLocParam is equal to 0 the following applies:
- If sig_flag is equal to 0, ctxlnc is set to stateld*3.
- Otherwise, if sign_flag is equal to 0, ctxlnc is set to stateld*3+1.
- Otherwise, ctxlnc is set to stateld*3+2.
- If coLocParam is not equal to 0 the following applies:
- If coLocParam is greater than 1 or less than -1, ctxlnc is set to stateld*2+24.
- Otherwise, ctxInc is set to stateld*2+25.

Further embodiments according to the invention may comprise a derivation process of ctxlnc for the syntax element sign_flag.

Inputs to this process may, for example, be the sig_flag decoded before the current sig_flag, the associated sign_flag, if present, and, if present, the co-located parameter level (coLocParam) from the incremental update decoded before the current incremental update. If no sig_flag was decoded before the current sig_flag, it may, for example, be inferred to be 0. If no sign_flag associated with the previously decoded sig_flag was decoded, it may, for example, be inferred to be 0. If no co-located parameter level from an incremental update decoded before the current incremental update is avaiable, it may, for example, be inferred to be 0. A co-located parameter level means the parameter level in the same tensor at the same position in previously decoded incremental update.

Output of this process may, for example, be the variable ctxInc.

The variable ctxlnc may, for example, be derived as follows:
- If coLocParam is equal to 0 the following may apply:
- If sig_flag is equal to 0, ctxlnc may, for example, be set to 0.
- Otherwise, if sign_flag is equal to 0, ctxlnc may, for example, be set to 1.
- Otherwise, ctxlnc may, for example, be set to 2.
- If coLocParam is not equal to 0 the following may apply:
- If coLocParam is less than 0, ctxlnc may, for example, be set to 3.
- Otherwise, ctxlnc may, for example, be set to 4.

Further embodiments may comprise a derivation process of ctxlnc for the syntax element abs_level_greater_x[j]

Inputs to this process may, for example, be the sign_flag decoded before the current syntax element abs_level_greater_x[j] and, if present, the co-located parameter level (coLocParam) from the incremental update decoded before the current incremental update. If no co-located parameter level from an incremental update decoded before the current incremental update is available, it may, for example, be inferred to be 0. A co-located parameter level means the parameter level in the same tensor at the same position in previously decoded incremental update.

Output of this process may, for example, be the variable ctxlnc.

The variable ctxlnc may, for example, be derived as follows:
- If coLocParam is equal to zero the following may apply:
- If sign_flag is equal to 0, ctxlnc may, for example, be set to 2*j.
- Otherwise, ctxlnc may, for example, be set to 2*j+1.
- If coLocParam is not equal to zero the following may apply:
- If coLocParam is greater or equal to j or is lower or equal to -j, ctxlnc may, for example, be set to 2*j+2* maxNumNoRemMinus1
- Otherwise, ctxlnc may, for example, be set to 2*j + 2* macNumNoRemMinus1 +1.

Further remarks:
In the following, different inventive embodiments and aspects will be described in a chapter "Introduction", and in a chapter "Parameter update tree (PUT) (example)" and their respective subchapters.

Also, further embodiments will be defined by the enclosed claims.

It should be noted that any embodiments as defined by the claims can be supplemented by any of the details (features and functionalities) described in the above mentioned chapters and/or subchapters respectively and/or by any of the details (features and functionalities) described in the above disclosure.

Also, the embodiments described in the above mentioned chapters and/or subchapters can be used individually, and can also be supplemented by any of the features in another chapter, or by any feature included in the claims.

Also, it should be noted that individual aspects described herein can be used individually or in combination. Thus, details can be added to each of said individual aspects without adding details to another one of said aspects.

It should also be noted that the present disclosure describes, explicitly or implicitly, features usable in a neural network encoder (apparatus for providing an encoded representation of neural network parameters) and in a neural network decoder (apparatus for providing a decoded representation of neural network parameters on the basis of an encoded representation). Thus, any of the features described herein can be used in the context of a neural network encoder and in the context of a neural network decoder.

Moreover, features and functionalities disclosed herein relating to a method can also be used in an apparatus (configured to perform such functionality). Furthermore, any features and functionalities disclosed herein with respect to an apparatus can also be used in a corresponding method. In other words, the methods disclosed herein can be supplemented by any of the features and functionalities described with respect to the apparatuses.

Also, any of the features and functionalities described herein can be implemented in hardware or in software, or using a combination of hardware and software, as will be described in the section "implementation alternatives".

The following section (comprising for example subsections or chapters 1 to 2) may be titled efficient signaling of neural network updates in distributed scenarios

### 1. Introduction

In the following, background information of embodiments according to the invention is provided. However, features and/or functionalities and/or details and/or aspects explained in this chapter may optionally be incorporated in a plurality of embodiments of the invention, both individually and taken in combination. Embodiments according to the invention may comprise or may be used with said aspects and/or features.

As Neural Networks (NN) have led to break-throughs in many application areas, also efficient transmission mechanisms are developing. This may allow e.g. for carrying out the, for example possible complex, NN training process, for example, in central server devices and optionally may allow to transmit a trained NN e.g. to client devices. Here, neural network compression and representation has been standardized recently. A newer field of applications are federated learning (FL) and training scenarios, where NNs may be trained, for example, on many devices, for example at the same time. In FL scenarios, e.g. frequent communication between client devices and central server devices may be beneficial or even required. Initially, a first version of a pre-trained NN may be sent to all clients, for example, for further training, using e.g. neural network compression. Then, all clients may further train the NN, and may send an updated NN version to one (or more) servers, for example as shown in Figure 14.

Fig. 14 shows a schematic view of an example of federated learning scenario according to embodiments of the invention. Fig. 14 shows a plurality of clients 1410, 1420, 1430, that may be configured to train neural networks. A server 1430 may receive training results, e.g. updates, of respective clients and may, based on the training results, e.g. neural network parameters, provide aggregated updated neural network parameters to the clients.

An update may e.g. be a difference signal between the initial NN and the newer NN version, for example, at the client. Accordingly, one or more, or for example all arrows between server and clients (e.g. in Figure 14) may represent sending an NN update. The server may then collect some or, for example, all local client versions and may aggregate a new server version of the NN. The aggregation process can, for example, be a simple averaging of a plurality or for example all available network version, or a more advanced process, such as, for example, only averaging output labels. This latter method is known as federated distillation and may allow for, for example, much more flexibility, for example, at local clients. This can, for example, even include different networks and/or topologies, for example, at each client, for example, as long as the output labels of all client versions can still be aggregated at a server. The process up to here is also called a communication round (CR). Then, for example, the new server version may be sent again to a plurality or for example all clients, e.g. also as difference signal to a previous NN version, for example, for further training and the process may repeat. The FL scenario may continue for many CRs, e.g. until a certain precision (for inference) is reached. In general, FL scenarios may allow communication flexibility. In a synchronous communication scenario, a plurality or for example all N clients may send updates in each communication round, the server may aggregate the versions or for example the N versions into a new version and may then send this version to the plurality or for example all N clients, for example, for the next CR. In an asynchronous FL scenario, clients may only send updates after a certain number of CRs. Or may send updates for a successive number of CRs and may then pause for a certain time. This may mean that a server may only have a subset K < N client versions at a certain CR, for example, for aggregating a new server version, for example, to be sent to the clients.

Many or for example all these conditions in federated scenarios may require specific signaling, for example, in order to handle the different FL variations, but optionally also, for example, to increase coding efficiency of NN update and/or difference data to be sent between server(s) and clients (e.g. in both directions). Accordingly, the following subsections describe related aspects of the invention.

### 2. Parameter update tree (PUT) (example)

As an example, considering a, for example distributed, scenario according to embodiments with several devices (e.g. including server and client devices) and, for example, a so-called base model, which may be a neural network for which updates shall be or may be transmitted between devices. Embodiments according to this invention comprise and/or describe a scheme for representing such updates, for example, using a tree structure. A plurality or for example each individual parameter (or a group of parameters) of the base model may be associated with the root node of a tree, e.g. the tree having the beforementioned tree structure. An update for such a parameter may correspond to a child node attached to the root node. The child node may contain instructions, for example, on how to update the parameter associated with the parent node. Any node of the tree may further be updated, for example, by attaching child nodes in the same manner. An example is given in Fig. 15 where R is the root node representing one parameter of the base model.

Fig. 15 shows a schematic view of an example of parameter update tree, for example exemplary parameter update tree, according to embodiments of the invention.

Nodes U1 and U2 may describe updates to node R and node U3 may describe an update of node U2. Each node of the tree may represent a version of the parameter of the base model R and one could, for example, decide to execute the model using a particular updated version U1, U2, or U3 instead of R. In other words, according to embodiments a decoder may, for example, be configured to decide to execute the model using a particular updated version U1, U2, or U3 instead of R, for example corresponding to a specific version of neural network parameters.

In order to represent such a tree, a unique node identifier may be associated with a plurality of nodes or for example each node. For example, this could be or may be an integer number, a string, and/or a cryptographic hash (like e.g. SHA-512) associated with the node. However, within such a tree, each node identifier may be unique or for example must even be unique.

In a distributed scenario, a plurality of devices or for example each device (e.g. server or client) may maintain update trees, for example, for the parameters of the model. For example, in order to transmit a particular update from one device to another, for example only, the corresponding update along with the associated node identifier (e.g. a pointer to the parent node of the update) may be transmitted or may need to be transmitted.

In the following an example according to embodiments is disclosed in order to provide a better understanding of aspects of the invention. For example, consider a client and a server that both have node R (e.g. as in Figure 15) available. Assume, the client creates update U2 and wants to make it available to the server. For this it may send U2 along with the node identifier of R to the server. The server may search for the node identifier of R in its version of the tree and may append U2 as a child node of R. Now, server and client may both have a tree available with R as root node and U2 as a child node of R.

### 2.1 Parameter update procedure (example)

This section describes several different types of update instructions, for example, associated with nodes of a PUT according to embodiments of the invention. The parameter of the base model that may be associated with a PUT may be or shall be denoted tree parameter. For example, a so-called node parameter may be or shall be associated with each node of the PUT. However, in other example, a so-called node parameter may or shall be associated with, for example, a set of nodes, e.g. a reachable (e.g. reachable from the root node to a specific current node) set of nodes, or, for example, a set of consecutive nodes, starting from the root node, of the PUT, or, for example, associated with each node of the PUT. This node parameter may be derived by traversing the PUT, for example, from the root node to the desired node and applying the update instructions, for example, of each visited node to the tree parameter. For example (e.g. as in Figure 15), the node parameter of R may equal the tree parameter and the node parameter of U1 may equal the tree parameter, for example, after applying update instructions of U1.

In the case where a node parameter (and, for example, consequently also the tree parameter) is a tensor (i.e., for example, a multi-dimensional arrays of values), it may be or shall be denoted node tensor.

In a preferred embodiment, update instructions, for example, associated with a node may contain a so-called product tensor, for example, of the same shape as the node tensor. Updating the parameter may correspond to an element-wise product, for example, of the node tensor elements and the product tensor elements.

In a preferred embodiment, update instructions, for example, associated with a node may contain at least one of a so-called sum tensor, for example, of the same shape as the node tensor, a scalar node tensor weight value, and/or a scalar sum tensor weight value. Updating the parameter may correspond to an element-wise weighted sum, for example, of the node tensor elements and the sum tensor elements. As an example, or for example more precisely, each element of the node tensor may be multiplied with the node tensor weight value, each element of the sum tensor may be multiplied with the sum tensor weight value, and then, the element-wise sum of both scaled tensors may be calculated. Note that both weights may also be set to 1, which may correspond to a non-weighted sum, for example, as a special case.

In another preferred embodiment, update instructions, for example, associated with a node may contain a so-called replace tensor, for example, of the same shape as the node tensor. Updating the parameter may correspond to replacing the values of the node tensor, for example, with the values of the replace tensor.

In another preferred embodiment, update instructions that employ an update tensor (as for example a replace tensor, a sum tensor, and/or a product tensor) may involve an, for example implicit, tensor shape conversion, for example, as follows.

In the following an example according to embodiments is disclosed in order to provide a better understanding of aspects of the invention.

Assume, the update tensor shape is identical to the node tensor shape except for one or more individual dimensions, which may equal 1. For example, for dimensions of the update tensor that are 1, it may be or shall be assumed that tensor elements along this axis are the same. For example, assume, the node tensor is given as 2D tensor [[a, b, c], [d, e, f]] (dimensions are [2, 3]). An update tensor given as [[x],[y]] (dimensions are [2, 1]) may or would implicitly be extended to [[x, x, x], [y, y, y]]. An update tensor given as [[z]] (dimensions are [1, 1]) may or would implicitly be extended to [[z, z, z], [z, z, z]]. An update tensor given as [[r, s, t]] (dimensions are [1, 3]) may or would implicitly be extended to [[r, s, t], [r, s, t]]. In other words, a decoder according to embodiments may, for example, be configured to update a tensor shape according to the example explained above.
- TBD: quantized-domain updates (check effects of different qps) (optional)

Optionally, quantized domain updates may, for example, be used (e.g. alternatively, or in combination with the above concepts).

### 2.2 Server-side update aggregation example

In a distributed scenario, according to embodiments of the invention, where a server may maintain a base model and, for example, may receive updates from, for example, different clients, the PUT at the server side may collect several update nodes, for example, for the same model. The server may decide to combine several update nodes and may, for example, create a new update node, for example, from this combination and may for example distribute it to the clients, for example, as a collectively updated model. A plurality or for example each node may then decide to continue federated learning, for example, based on this collectively updated model.

### 2.3 Parameter update tree signaling (example)

This section presents methods for representing elements of a PUT, for example, as data units (e.g. byte sequences) e.g. optimized for transmission between devices (e.g. including servers and clients) according to embodiments of the invention. It, for example the methods, may be combined with existing techniques for representing neural networks like, e.g., the emerging standard "ISO/IEC 15938 Part 17: Compression of neural networks for multimedia content description and analysis", which is referred to as NNR throughout this document. NNR may represent individual parameters of a neural network as so-called compressed data units (NDU). Implementing the PUT concept, for example, by using the efficient compression techniques available in NNR can, for example, be carried out as follows. In accord with embodiments of the invention, consider the case where a node contains an update tensor (for example or like a replace tensor, a sum tensor, and/or a product tensor, for example, as described above). Such an update tensor can be, for example efficiently, represented as an NDU. In order to extend an NDU with, for example all necessary, information, for example, so that it can be used as a PUT node, further syntax elements can, for example, be added.

In a preferred embodiment, a new syntax element "parent_node_id_present_flag" may be introduced, for example, into the nnr_compressed_data_unit_header of an NDU, for example indicating whether a parent node identifier is present in the NDU. Depending on the value of parent_node_id_present_flag, a further new syntax element "parent_node_id" may be transmitted that, for example, uniquely identifies another NDU that may contain the parent node of the current PUT node.

In another preferred embodiment, the parent_node_id may be a cryptographic hash (like, e.g., SHA-512) of the parent NDU.

In another preferred embodiment, the parent_node_id may be a cryptographic hash (like, e.g., SHA-512) of the nnr_compressed_data_unit_payload of the parent NDU.

In another preferred embodiment, the parent_node_id may be a combined value representing a device identifier and/or a serial number of which both may, for example, be associated with the parent NDU.

In another preferred embodiment, a new syntax element "node_id" may be encoded in the parent node, to be used as parent_node_id of child nodes of the parent node. node_id may, for example, be a unique identifier.

In another preferred embodiment, syntax element "node_id" (which may, for example, uniquely identify a node) may be composed of a device identifier and/or a parameter update tree depth information (i.e., for example an, information about the number of nodes visited when walking the tree from the current node to the root node) and/or a parameter update tree identifier.

In another preferred embodiment, a flag may be signaled for a node, indicating whether a node_id is present. Depending on the value of this flag, a syntax element node_id may be present or not.

In another preferred embodiment, a new syntax element "parent_node_id_type" may indicate of which type the syntax element parent_node_id is. For example, possible different types of parent_node_id may be as described in the previous preferred embodiments.

In another preferred embodiment, it may depend on the value of syntax element parent_node_id_present_flag whether syntax element parent_node_id_type is signaled or not.

### 2.3.1 Topology change signaling (example)

In a distributed scenario, it may sometimes be of interest to change the topology of a neural network. For example, the number of output neurons of a particular layer may or could be increased or decreased.

In a preferred embodiment, a syntax element "shape_update" may be signaled within an NDU, for example, indicating whether the shape of the tensor associated with the parent node is modified or not. In the case where the parent tensor shape is updated, new tensor dimensions may be transmitted (e.g. using syntax element tensor_dimensions).

### Implementation alternatives:

Although some aspects are described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, one or more of the most important method steps may be executed by such an apparatus.

Depending on certain implementation requirements, embodiments of the invention can be implemented in hardware or in software. The implementation can be performed using a digital storage medium, for example a floppy disk, a DVD, a Blu-Ray, a CD, a ROM, a PROM, an EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein. The data carrier, the digital storage medium or the recorded medium are typically tangible and/or non-transitionary.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The apparatus described herein may be implemented using a hardware apparatus, or using a computer, or using a combination of a hardware apparatus and a computer.

The apparatus described herein, or any components of the apparatus described herein, may be implemented at least partially in hardware and/or in software.

The methods described herein may be performed using a hardware apparatus, or using a computer, or using a combination of a hardware apparatus and a computer.

The methods described herein, or any components of the apparatus described herein, may be performed at least partially by hardware and/or by software.

The described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

## Claims

1. A decoder (100, 100b) for decoding parameters of a neural network,
wherein the decoder is configured to obtain a plurality of neural network parameters (104, 104b, 204, 304, 512, 522, 532, 542, 552, 562, 572, 582, 592, 602 ,612, 622, 652, 720, 740, 812) of the neural network on the basis of an encoded bitstream;
wherein the decoder is configured to obtain a node information (112, 112b) describing a node of a parameter update tree, the parameter update tree comprising nodes that are in a hierarchical order;
wherein the node information comprises a parent node identifier (114, 524, 534, 544, 554, 564, 574, 584, 594, 604, 614, 624), and
wherein the node information comprises a parameter update information (116, 526, 536, 546, 556, 566, 576, 586, 596, 606, 616, 626);
wherein the decoder is configured to derive one or more neural network parameters (104, 104b, 204, 304, 512, 522, 532, 542, 552, 562, 572, 582, 592, 602 ,612, 622, 652, 720, 740, 812) using parameter information of a parent node identified by the parent node identifier and using the parameter update information;
wherein the parent node comprises an own parent node identifier and an own parameter update information, and
wherein the decoder is configured to recursively derive predecessor nodes of the parent node until a node is reached for which neural network parameters are available, and
wherein the decoder is configured to update these neural network parameters based on the parameter update information of the derived nodes, the parent node and the parameter update information of the node information.

2. Decoder (100, 100b) according to claim 1, wherein the decoder is configured to modify one or more neural network parameters defined by the parent node, which is identified by the parent node identifier (114, 524, 534, 544, 554, 564, 574, 584, 594, 604, 614, 624), using the parameter update information (116, 526, 536, 546, 556, 566, 576, 586, 596, 606, 616, 626).

3. Decoder (100, 100b) according to any of the preceding claims, wherein the decoder is configured to set up a parameter update tree (500), wherein a plurality of child nodes comprising different parameter update information (116, 526, 536, 546, 556, 566, 576, 586, 596, 606, 616, 626) are associated with a common parent node (510).

4. Decoder (100, 100b) according to claim 3, wherein the decoder is configured to obtain one or more neural network parameters associated with a currently considered node using the parameter update information (116, 526, 536, 546, 556, 566, 576, 586, 596, 606, 616, 626) associated with the currently considered node, using a parameter information (512) associated with a root node (510) and using parameter update information associated with one or more intermediate nodes which are between the root node and the currently considered node in the update tree.

5. Decoder (100, 100b) according to any of claims 3 to 4, wherein the decoder is configured to traverse the parameter update tree (500) from a root node (510) to a currently considered node, and
wherein the decoder is configured to apply update instructions of visited nodes to one or more initial neural network parameters, in order to obtain one or more neural network parameters associated with the currently considered node.

6. Decoder (100, 100b) according to any of the claims 3 to 5, wherein the decoder is configured to aggregate
a plurality of consecutive nodes (520, 550) of the parameter update tree and/or
one or more consecutive nodes (520, 550) of the parameter update tree and the parameter update information.

7. Decoder (100, 100b) according to any of the claims 3 to 6, wherein the decoder is configured to update the parameter update tree (500) based on the node information (112, 112b).

8. Decoder (100, 100b) according to any of the preceding claims, wherein the decoder is configured to decide to choose neural network parameters (512) associated with a root node (510) or to choose neural network parameters associated with one of the descendent nodes of the root node.

9. Decoder (100, 100b) according to any of the preceding claims, wherein the parameter update information (116, 526, 536, 546, 556, 566, 576, 586, 596, 606, 616, 626) comprises an update instruction (526, 536, 546, 556, 566, 586) defining an addition of one or more change values to one or more parameter values associated with a parent node of a currently considered node and/or a subtraction of one or more change values from one or more parameter values associated with a parent node of a currently considered node; and
wherein the decoder is configured to apply an addition or subtraction of the change values defined by the update instruction, in order to obtain one or more neural network parameters (522, 532, 542, 552, 562, 582) associated with the currently considered node.

10. Decoder (100, 100b) according to any of the preceding claims, wherein the decoder is configured to determine whether a parent node identifier (114, 524, 534, 544, 554, 564, 574, 584, 594, 604, 614, 624) is present; and
wherein the decoder is configured to derive one or more neural network parameters according to any of the preceding claims if the parent node identifier (114, 524, 534, 544, 554, 564, 574, 584, 594, 604, 614, 624) is present, and
wherein the decoder is configured to make the currently considered node the root node (510) if the parent node identifier is not present.

11. Decoder (100, 100b) according to any of the preceding claims, wherein the decoder is configured to compare the parent node identifier (114, 524, 534, 544, 554, 564, 574, 584, 594, 604, 614, 624) with hash values associated with one or more nodes, to identify the parent node of the currently considered node.

12. Decoder (100, 100b) according to claim 11, wherein the hash values are hash values of a payload portion of a compressed data unit NDU associated with one or more previously decoded nodes, while leaving a data size information and a header information unconsidered.

13. Decoder (100, 100b) according to any of the claims 11 to 12, wherein the parent node identifier (114, 524, 534, 544, 554, 564, 574, 584, 594, 604, 614, 624) is a combined value representing a device identifier and a serial number of which both are associated with the parent node.

14. Decoder (100, 100b) according to any of claims 1 to 13,
wherein the node information (112,112b) comprises a node identifier.

15. Decoder (100, 100b) according to any of claims 1 to 14,
wherein the decoder is configured to store the node identifier.

16. Decoder (100, 100b) according to any of claims 1 to 15,
wherein the decoder is configured to compare one or more stored node identifiers with a parent node identifier (114, 524, 534, 544, 554, 564, 574, 584, 594, 604, 614, 624) in a node information (112, 112b) of a new node when adding the new node, in order to identify a parent node of the new node.

17. Decoder (100, 100b) according to any of claims 1 to 16,
wherein the node identifier comprises a device identifier and/or a parameter update tree depth information and/or a parameter update tree identifier.

18. Decoder (100, 100b) according to any of claims 1 to 17,
wherein the node information (112, 112b) comprises a signaling indicating whether a node identifier is present or not.

19. Decoder (100, 100b) according to any of the claims 10 to 18, wherein the decoder is configured to obtain a signaling (202, 302, 302b), comprising an information about the type of the parent node identifier (114, 524, 534, 544, 554, 564, 574, 584, 594, 604, 614, 624), and wherein the decoder is configured to evaluate the signaling in order to consider the respective type of the parent node identifier.

20. Decoder (100, 100b) according to one of claims 1 to 19, wherein the decoder is configured to selectively evaluate a syntax element which indicates a type of the parent node identifier, in dependence on a syntax element indicating the presence of the parent node identifier (114, 524, 534, 544, 554, 564, 574, 584, 594, 604, 614, 624).

21. An encoder (200, 300, 300b, 400) for encoding parameters of a neural network in order to obtain an encoded bitstream,
wherein the encoder is configured to provide a node information (212, 312, 312b, 412) describing a node of a parameter update tree (500), the parameter update tree comprising nodes that are in a hierarchical order;
wherein the node information comprises a parent node identifier (214, 314, 524, 534, 544, 554, 564, 574, 584, 594, 604, 614, 624), and
wherein the node information comprises a parameter update information (216, 316, 416, 526, 536, 546, 556, 566, 576, 586, 596, 606, 616, 626);
wherein the parameter update information describes differences between neural network parameters associated with a parent node defined by the parent node identifier and one or more current neural network parameters;
wherein the encoder is configured to determine differences between one or more neural network parameters defined by the parent node, which is identified by the parent node identifier (214, 314, 524, 534, 544, 554, 564, 574, 584, 594, 604, 614, 624), and the one or more current neural network parameters, in order to obtain the parameter update information (216, 316, 416, 526, 536, 546, 556, 566, 576, 586, 596, 606, 616, 626);
wherein the encoder is configured to provide the node information (212, 312, 312b, 412) such that it is possible to obtain one or more neural network parameters associated with a currently considered node using the parameter update information (216, 316, 416, 526, 536, 546, 556, 566, 576, 586, 596, 606, 616, 626) associated with the currently considered node, using a parameter information associated with a root node (510) and using parameter update information associated with one or more intermediate nodes which are between the root node and the currently considered node in the update tree.

22. Method (1000) for decoding parameters of a neural network, the method comprising
obtaining (1010) a plurality of neural network parameters of the neural network on the basis of an encoded bitstream;
obtaining (1020) a node information describing a node of a parameter update tree, the parameter update tree comprising nodes that are in a hierarchical order;
wherein the node information comprises a parent node identifier, and
wherein the node information comprises a parameter update information; and
deriving (1030) one or more neural network parameters using parameter information of a parent node identified by the parent node identifier and using the parameter update information;
wherein the parent node comprises an own parent node identifier and an own parameter update information, and
wherein the method further comprises
recursively deriving predecessor nodes of the parent node until a node is reached for which neural network parameters are available, and
updating these neural network parameters based on the parameter update information of the derived nodes, the parent node and the parameter update information of the node information.

23. Method (1100) for encoding parameters of a neural network in order to obtain an encoded bitstream, the method comprising
providing (1110) a node information describing a node of a parameter update tree, the parameter update tree comprising nodes that are in a hierarchical order;
wherein the node information comprises a parent node identifier, and
wherein the node information comprises a parameter update information;
wherein the parameter update information describes differences between neural network parameters associated with a parent node defined by the parent node identifier and one or more current neural network parameters;
wherein the method further comprises
determining differences between one more neural network parameters defined by the parent node, which is identified by the parent node identifier (214, 314, 524, 534, 544, 554, 564, 574, 584, 594, 604, 614, 624), and the one or more current neural network parameters, in order to obtain the parameter update information (216, 316, 416, 526, 536, 546, 556, 566, 576, 586, 596, 606, 616, 626); and
providing the node information (212, 312, 312b, 412), such that it is possible to obtain one or more neural network parameters associated with a currently considered node using the parameter update information (216, 316, 416, 526, 536, 546, 556, 566, 576, 586, 596, 606, 616, 626) associated with the currently considered node, using a parameter information associated with a root node (510) and using parameter update information associated with one or more intermediate nodes which are between the root node and the currently considered node in the update tree.

24. A computer program for performing the method according to one of claims 22 to 23, when the computer program runs on a computer.

## Patentansprüche

1. Ein Decodierer (100, 100b) zum Decodieren von Parametern eines neuronalen Netzwerks,
wobei der Decodierer dazu konfiguriert ist, eine Mehrzahl von Parametern (104, 104b, 204, 304, 512, 522, 532, 542, 552, 562, 572, 582, 592, 602, 612, 622, 652, 720, 740, 812) des neuronalen Netzwerks auf der Basis eines codierten Bitstroms zu erhalten;
wobei der Decodierer dazu konfiguriert ist, eine Knoteninformation (112, 112b) zu erhalten, die einen Knoten eines Parameteraktualisierungsbaums beschreibt, wobei der Parameteraktualisierungsbaum Knoten aufweist, die in einer hierarchischen Reihenfolge sind;
wobei die Knoteninformation einen Elternknotenidentifizierer (114, 524, 534, 544, 554, 564, 574, 584, 594, 604, 614, 624) aufweist, und
wobei die Knoteninformation eine Parameteraktualisierungsinformation (116, 526, 536, 546, 556, 566, 576, 586, 596, 606, 616, 626) aufweist;
wobei der Decodierer dazu konfiguriert ist, einen oder mehrere Parameter (104, 104b, 204, 304, 512, 522, 532, 542, 552, 562, 572, 582, 592, 602, 612, 622, 652, 720, 740, 812) des neuronalen Netzwerks unter Verwendung von Parameterinformationen eines Elternknotens, der durch den Elternknotenidentifizierer identifiziert wird, und unter Verwendung der Parameteraktualisierungsinformation abzuleiten;
wobei der Elternknoten einen eigenen Elternknotenidentifizierer und eine eigene Parameteraktualisierungsinformation aufweist, und
wobei der Decodierer dazu konfiguriert ist, Vorgängerknoten des Elternknotens rekursiv abzuleiten, bis ein Knoten erreicht ist, für den Parameter des neuronalen Netzwerks verfügbar sind, und
wobei der Decodierer dazu konfiguriert ist, diese Parameter des neuronalen Netzwerks basierend auf den Parameteraktualisierungsinformationen der abgeleiteten Knoten, dem Elternknoten und der Parameteraktualisierungsinformationen der Knoteninformation zu aktualisieren.

2. Decodierer (100, 100b) gemäß Anspruch 1, wobei der Decodierer dazu konfiguriert ist, einen oder mehrere Parameter des neuronalen Netzwerks, die durch den Elternknoten definiert sind, der durch den Elternknotenidentifizierer (114, 524, 534, 544, 554, 564, 574, 584, 594, 604, 614, 624) identifiziert wird, unter Verwendung der Parameteraktualisierungsinformationen (116, 526, 536, 546, 556, 566, 576, 586, 596, 606, 616, 626) zu modifizieren.

3. Decodierer (100, 100b) gemäß einem der vorhergehenden Ansprüche, wobei der Decodierer dazu konfiguriert ist, einen Parameteraktualisierungsbaum (500) einzurichten, wobei eine Mehrzahl von Kindknoten, die unterschiedliche Parameteraktualisierungsinformationen (116, 526, 536, 546, 556, 566, 576, 586, 596, 606, 616, 626) aufweisen, einem gemeinsamen Elternknoten (510) zugeordnet sind.

4. Decodierer (100, 100b) gemäß Anspruch 3, wobei der Decodierer dazu konfiguriert ist, einen oder mehrere Parameter des neuronalen Netzwerks, die einem aktuell betrachteten Knoten zugeordnet sind, zu erhalten unter Verwendung der Parameteraktualisierungsinformationen (116, 526, 536, 546, 556, 566, 576, 586, 596, 606, 616, 626), die dem aktuell betrachteten Knoten zugeordnet sind, unter Verwendung einer Parameterinformation (512), die einem Wurzelknoten (510) zugeordnet ist, und unter Verwendung von Parameteraktualisierungsinformationen, die einem oder mehreren Zwischenknoten zugeordnet sind, die zwischen dem Wurzelknoten und dem aktuell betrachteten Knoten in dem Aktualisierungsbaum liegen.

5. Decodierer (100, 100b) gemäß einem der Ansprüche 3 bis 4, wobei der Decodierer dazu konfiguriert ist, den Parameteraktualisierungsbaum (500) von einem Wurzelknoten (510) zu einem aktuell betrachteten Knoten zu durchlaufen, und
wobei der Decodierer dazu konfiguriert ist, Aktualisierungsanweisungen von besuchten Knoten an einen oder mehrere anfängliche Parameter des neuronalen Netzwerks anzuwenden, um einen oder mehrere Parameter des neuronalen Netzwerks zu erhalten, die dem aktuell betrachteten Knoten zugeordnet sind.

6. Decodierer (100, 100b) gemäß einem der Ansprüche 3 bis 5, wobei der Decodierer dazu konfiguriert ist, Folgendes zu sammeln:
eine Mehrzahl von aufeinanderfolgenden Knoten (520, 550) des Parameteraktualisierungsbaums und/oder
einen oder mehrere aufeinanderfolgende Knoten (520, 550) des Parameteraktualisierungsbaums und die Parameteraktualisierungsinformationen.

7. Decodierer (100, 100b) gemäß einem der Ansprüche 3 bis 6, wobei der Decodierer dazu konfiguriert ist, den Parameteraktualisierungsbaum (500) basierend auf der Knoteninformation (112, 112b) zu aktualisieren.

8. Decodierer (100, 100b) gemäß einem der vorhergehenden Ansprüche, wobei der Decodierer dazu konfiguriert ist, zu entscheiden, Parameter des neuronalen Netzwerks (512) auszuwählen, die einem Wurzelknoten (510) zugeordnet sind, oder Parameter des neuronalen Netzwerks auszuwählen, die einem der Nachkommen-Knoten des Wurzelknotens zugeordnet sind.

9. Decodierer (100, 100b) gemäß einem der vorhergehenden Ansprüche, wobei die Parameteraktualisierungsinformationen (116, 526, 536, 546, 556, 566, 576, 586, 596, 606, 616, 626) eine Aktualisierungsanweisung (526, 536, 546, 556, 566, 586) aufweisen, die eine Addition von einem oder mehreren Änderungswerten zu einem oder mehreren Parameterwerten, die einem Elternknoten eines aktuell betrachteten Knotens zugeordnet sind, und/oder eine Subtraktion von einem oder mehreren Änderungswerten von einem oder mehreren Parameterwerten definiert, die einem Elternknoten eines aktuell betrachteten Knotens zugeordnet sind; und
wobei der Decodierer dazu konfiguriert ist, eine Addition oder Subtraktion der durch die Aktualisierungsanweisung definierten Änderungswerte anzuwenden, um einen oder mehrere Parameter des neuronalen Netzwerks (522, 532, 542, 552, 562, 582) zu erhalten, die dem aktuell betrachteten Knoten zugeordnet sind.

10. Decodierer (100, 100b) gemäß einem der vorhergehenden Ansprüche, wobei der Decodierer dazu konfiguriert ist, zu bestimmen, ob ein Elternknotenidentifizierer (114, 524, 534, 544, 554, 564, 574, 584, 594, 604, 614, 624) vorhanden ist; und
wobei der Decodierer dazu konfiguriert ist, einen oder mehrere Parameter des neuronalen Netzwerks gemäß einem der vorhergehenden Ansprüche abzuleiten, wenn der Elternknotenidentifizierer (114, 524, 534, 544, 554, 564, 574, 584, 594, 604, 614, 624) vorhanden ist, und
wobei der Decodierer dazu konfiguriert ist, den aktuell betrachteten Knoten zum Wurzelknoten (510) zu machen, wenn der Elternknotenidentifizierer nicht vorhanden ist.

11. Decodierer (100, 100b) gemäß einem der vorhergehenden Ansprüche, wobei der Decodierer dazu konfiguriert ist, den Elternknotenidentifizierer (114, 524, 534, 544, 554, 564, 574, 584, 594, 604, 614, 624) mit Hash-Werten zu vergleichen, die einem oder mehreren Knoten zugeordnet sind, um den Elternknoten des aktuell betrachteten Knotens zu identifizieren.

12. Decodierer (100, 100b) gemäß Anspruch 11, wobei die Hash-Werte eines Nutzdatenabschnitts einer komprimierten Dateneinheit NDU sind, die einem oder mehreren zuvor decodierten Knoten zugeordnet sind, während eine Datengrößeninformation und eine Anfangsblockinformation unberücksichtigt gelassen werden.

13. Decodierer (100, 100b) gemäß einem der Ansprüche 11 bis 12, wobei der Elternknotenidentifizierer (114, 524, 534, 544, 554, 564, 574, 584, 594, 604, 614, 624) ein kombinierter Wert ist, der einen Vorrichtungsidentifizierer und eine Seriennummer darstellt, von denen beide dem Elternknoten zugeordnet sind.

14. Decodierer (100, 100b) gemäß einem der Ansprüche 1 bis 13,
wobei die Knoteninformation (112, 112b) einen Knotenidentifizierer aufweist.

15. Decodierer (100, 100b) gemäß einem der Ansprüche 1 bis 14,
wobei der Decodierer dazu konfiguriert ist, den Knotenidentifizierer zu speichern.

16. Decodierer (100, 100b) gemäß einem der Ansprüche 1 bis 15,
wobei der Decodierer dazu konfiguriert ist, einen oder mehrere gespeicherte Knotenidentifizierer mit einem Elternknotenidentifizierer (114, 524, 534, 544, 554, 564, 574, 584, 594, 604, 614, 624) in einer Knoteninformation (112, 112b) eines neuen Knotens zu vergleichen, wenn der neue Knoten hinzugefügt wird, um einen Elternknoten des neuen Knotens zu identifizieren.

17. Decodierer (100, 100b) gemäß einem der Ansprüche 1 bis 16,
wobei der Knotenidentifizierer einen Vorrichtungsidentifizierer und/oder eine Parameteraktualisierungsbaumtiefeninformation und/oder einen Parameteraktualisierungsbaumidentifizierer aufweist.

18. Decodierer (100, 100b) gemäß einem der Ansprüche 1 bis 17,
wobei die Knoteninformation (112, 112b) eine Signalisierung aufweist, die angibt, ob ein Knotenidentifizierer vorhanden ist oder nicht.

19. Decodierer (100, 100b) gemäß einem der Ansprüche 10 bis 18, wobei der Decodierer dazu konfiguriert ist, eine Signalisierung (202, 302, 302b) zu erhalten, die eine Information über den Typ des Elternknotenidentifizierers (114, 524, 534, 544, 554, 564, 574, 584, 594, 604, 614, 624) aufweist, und wobei der Decodierer dazu konfiguriert ist, die Signalisierung auszuwerten, um den jeweiligen Typ des Elternknotenidentifizierers zu berücksichtigen.

20. Decodierer (100, 100b) gemäß einem der Ansprüche 1 bis 19, wobei der Decodierer dazu konfiguriert ist, ein Syntaxelement, das einen Typ des Elternknotenidentifizierers angibt, in Abhängigkeit von einem Syntaxelement, das das Vorhandensein des Elternknotenidentifizierers (114, 524, 534, 544, 554, 564, 574, 584, 594, 604, 614, 624) angibt, selektiv auszuwerten.

21. Ein Codierer (200, 300, 300b, 400) zum Codieren von Parametern eines neuronalen Netzwerks, um einen codierten Bitstrom zu erhalten,
wobei der Codierer dazu konfiguriert ist, eine Knoteninformation (212, 312, 312b, 412) bereitzustellen, die einen Knoten eines Parameteraktualisierungsbaums (500) beschreibt, wobei der Parameteraktualisierungsbaum Knoten aufweist, die in einer hierarchischen Reihenfolge sind;
wobei die Knoteninformation einen Elternknotenidentifizierer (214, 314, 524, 534, 544, 554, 564, 574, 584, 594, 604, 614, 624) aufweist, und
wobei die Knoteninformation eine Parameteraktualisierungsinformation (216, 316, 416, 526, 536, 546, 556, 566, 576, 586, 596, 606, 616, 626) aufweist;
wobei die Parameteraktualisierungsinformation Unterschiede zwischen Parametern des neuronalen Netzwerks, die einem Elternknoten zugeordnet sind, der durch den Elternknotenidentifizierer definiert ist, und einem oder mehreren aktuellen Parametern des neuronalen Netzwerks beschreibt;
wobei der Codierer dazu konfiguriert ist, Unterschiede zwischen einem oder mehreren Parametern des neuronalen Netzwerks, die durch den Elternknoten definiert sind, der durch den Elternknotenidentifizierer (214, 314, 524, 534, 544, 554, 564, 574, 584, 594, 604, 614, 624) identifiziert ist, und dem einen oder den mehreren aktuellen Parametern des neuronalen Netzwerks zu bestimmen, um die Parameteraktualisierungsinformation (216, 316, 416, 526, 536, 546, 556, 566, 576, 586, 596, 606, 616, 626) zu erhalten;
wobei der Codierer dazu konfiguriert ist, die Knoteninformation (212, 312, 312b, 412) derart bereitzustellen, dass es möglich ist, einen oder mehrere Parameter des neuronalen Netzwerks, die einem aktuell betrachteten Knoten zugeordnet sind, zu erhalten unter Verwendung der Parameteraktualisierungsinformation (216, 316, 416, 526, 536, 546, 556, 566, 576, 586, 596, 606, 616, 626), die dem aktuell betrachteten Knoten zugeordnet ist, unter Verwendung einer Parameterinformation, die einem Wurzelknoten (510) zugeordnet ist, und unter Verwendung von Parameteraktualisierungsinformationen, die einem oder mehreren Zwischenknoten zugeordnet sind, die zwischen dem Wurzelknoten und dem aktuell betrachteten Knoten in dem Aktualisierungsbaum liegen.

22. Ein Verfahren (1000) zum Decodieren von Parametern eines neuronalen Netzwerks, wobei das Verfahren folgende Schritte aufweist:
Erhalten (1010) einer Mehrzahl von Parametern des neuronalen Netzwerks auf der Basis eines codierten Bitstroms;
Erhalten (1020) einer Knoteninformation, die einen Knoten eines Parameteraktualisierungsbaums beschreibt, wobei der Parameteraktualisierungsbaum Knoten aufweist, die in einer hierarchischen Reihenfolge sind;
wobei die Knoteninformation einen Elternknotenidentifizierer aufweist, und
wobei die Knoteninformation eine Parameteraktualisierungsinformation aufweist; und
Ableiten (1030) eines oder mehrerer Parameter des neuronalen Netzwerks unter Verwendung von Parameterinformationen eines Elternknotens, der durch den Elternknotenidentifizierer identifiziert wird, und unter Verwendung der Parameteraktualisierungsinformation;
wobei der Elternknoten einen eigenen Elternknotenidentifizierer und eine eigene Parameteraktualisierungsinformation aufweist, und
wobei das Verfahren ferner folgende Schritte aufweist:
rekursives Ableiten von Vorgängerknoten des Elternknotens, bis ein Knoten erreicht ist, für den Parameter des neuronalen Netzwerks verfügbar sind, und
Aktualisieren dieser Parameter des neuronalen Netzwerks basierend auf den Parameteraktualisierungsinformationen der abgeleiteten Knoten, dem Elternknoten und den Parameteraktualisierungsinformationen der Knoteninformation.

23. Ein Verfahren (1100) zum Codieren von Parametern eines neuronalen Netzwerks, um einen codierten Bitstrom zu erhalten, wobei das Verfahren folgende Schritte aufweist:
Bereitstellen (1110) einer Knoteninformation, die einen Knoten eines Parameteraktualisierungsbaums beschreibt, wobei der Parameteraktualisierungsbaum Knoten aufweist, die in einer hierarchischen Reihenfolge sind;
wobei die Knoteninformation einen Elternknotenidentifizierer aufweist, und
wobei die Knoteninformation eine Parameteraktualisierungsinformation aufweist;
wobei die Parameteraktualisierungsinformation Unterschiede zwischen Parametern des neuronalen Netzwerks, die einem Elternknoten zugeordnet sind, der durch den Elternknotenidentifizierer definiert ist, und einem oder mehreren aktuellen Parametern des neuronalen Netzwerks beschreibt;
wobei das Verfahren ferner folgende Schritte aufweist:
Bestimmen von Unterschieden zwischen einem oder mehreren Parametern des neuronalen Netzwerks, die durch den Elternknoten definiert sind, der durch den Elternknotenidentifizierer (214, 314, 524, 534, 544, 554, 564, 574, 584, 594, 604, 614, 624) identifiziert ist, und dem einen oder den mehreren aktuellen Parametern des neuronalen Netzwerks, um die Parameteraktualisierungsinformation (216, 316, 416, 526, 536, 546, 556, 566, 576, 586, 596, 606, 616, 626) zu erhalten; und
Bereitstellen der Knoteninformation (212, 312, 312b, 412), so dass es möglich ist, einen oder mehrere Parameter des neuronalen Netzwerks, die einem aktuell betrachteten Knoten zugeordnet sind, zu erhalten unter Verwendung der Parameteraktualisierungsinformation (216, 316, 416, 526, 536, 546, 556, 566, 576, 586, 596, 606, 616, 626), die dem aktuell betrachteten Knoten zugeordnet sind, unter Verwendung einer Parameterinformation, die einem Wurzelknoten (510) zugeordnet ist, und unter Verwendung von Parameteraktualisierungsinformationen, die einem oder mehreren Zwischenknoten zugeordnet sind, die zwischen dem Wurzelknoten und dem aktuell betrachteten Knoten in dem Aktualisierungsbaum liegen.

24. Ein Computerprogramm zum Durchführen des Verfahrens gemäß einem der Ansprüche 22 bis 23, wenn das Computerprogramm auf einem Computer läuft.

## Revendications

1. Décodeur (100, 100b) destiné à décoder des paramètres d'un réseau neuronal,
dans lequel le décodeur est configuré pour obtenir une pluralité de paramètres de réseau neuronal (104, 104b, 204, 304, 512, 522, 532, 542, 552, 562, 572, 582, 592, 602,612, 622, 652, 720, 740, 812) du réseau neuronal sur la base d'un flux binaire codé ;
dans lequel le décodeur est configuré pour obtenir une information de nœud (112, 112b) décrivant un nœud d'un arbre de mise à jour de paramètre, l'arbre de mise à jour de paramètre comprenant des nœuds qui sont dans un ordre hiérarchique ;
dans lequel les informations de nœud comprennent un identifiant de nœud parent (114, 524, 534, 544, 554, 564, 574, 584, 594, 604, 614, 624), et
dans lequel les informations de nœud comprennent des informations de mise à jour de paramètre (116, 526, 536, 546, 556, 566, 576, 586, 596, 606, 616, 626) ;
dans lequel le décodeur est configuré pour dériver un ou plusieurs paramètres de réseau neuronal (104, 104b, 204, 304, 512, 522, 532, 542, 552, 562, 572, 582, 592, 602,612, 622, 652, 720, 740, 812) à l'aide des informations de paramètre d'un nœud parent identifié par l'identifiant du nœud parent et à l'aide des informations de mise à jour de paramètre ;
dans lequel le nœud parent comprend un identifiant propre au nœud parent et des informations propres à la mise à jour de paramètre, et
dans lequel le décodeur est configuré pour déterminer de manière récursive des nœuds prédécesseurs du nœud parent jusqu'à ce qu'un nœud soit atteint pour lequel des paramètres de réseau neuronal sont disponibles, et
dans lequel le décodeur est configuré pour mettre à jour ces paramètres de réseau neuronal sur la base des informations de mise à jour de paramètre des nœuds dérivés, du nœud parent et des informations de mise à jour de paramètre issues des informations de nœud.

2. Décodeur (100, 100b) selon la revendication 1, dans lequel le décodeur est configuré pour modifier un ou plusieurs paramètres de réseau neuronal définis par le nœud parent, qui est identifié par l'identifiant de nœud parent (114, 524, 534, 544, 554, 564, 574, 584, 594, 604, 614, 624), à l'aide des informations de mise à jour de paramètre (116, 526, 536, 546, 556, 566, 576, 586, 596, 606, 616, 626).

3. Décodeur (100, 100b) selon l'une quelconque des revendications précédentes, dans lequel le décodeur est configuré pour établir un arbre de mise à jour de paramètre (500), dans lequel une pluralité de nœuds enfants comprenant différentes informations de mise à jour de paramètre (116, 526, 536, 546, 556, 566, 576, 586, 596, 606, 616, 626) sont associés à un nœud parent commun (510).

4. Décodeur (100, 100b) selon la revendication 3, dans lequel le décodeur est configuré pour obtenir un ou plusieurs paramètres de réseau neuronal associés à un nœud actuellement considéré à l'aide des informations de mise à jour de paramètre (116, 526, 536, 546, 556, 566, 576, 586, 596, 606, 616, 626) associées au nœud actuellement considéré, à l'aide d'informations de paramètre (512) associées à un nœud racine (510) et à l'aide d'informations de mise à jour de paramètre associées à un ou plusieurs nœuds intermédiaires qui sont entre le nœud racine et le nœud actuellement considéré dans l'arbre de mise à jour.

5. Décodeur (100, 100b) selon l'une quelconque des revendications 3 à 4, dans lequel le décodeur est configuré pour parcourir l'arbre de mise à jour de paramètre (500) depuis un nœud racine (510) jusqu'à un nœud actuellement considéré, et
dans lequel le décodeur est configuré pour appliquer des instructions de mise à jour des nœuds visités à un ou plusieurs paramètres initiaux du réseau neuronal, afin d'obtenir un ou plusieurs paramètres du réseau neuronal associés au nœud actuellement considéré.

6. Décodeur (100, 100b) selon l'une quelconque des revendications 3 à 5, dans lequel le décodeur est configuré pour agréger
une pluralité de nœuds consécutifs (520, 550) de l'arbre de mise à jour de paramètre et/ou
un ou plusieurs nœuds consécutifs (520, 550) de l'arbre de mise à jour de paramètre et les informations de mise à jour de paramètre.

7. Décodeur (100, 100b) selon l'une quelconque des revendications 3 à 6, dans lequel le décodeur est configuré pour mettre à jour l'arbre de mise à jour de paramètre (500) sur la base des informations de nœud (112, 112b).

8. Décodeur (100, 100b) selon l'une quelconque des revendications précédentes, dans lequel le décodeur est configuré pour décider de choisir des paramètres de réseau neuronal (512) associés à un nœud racine (510) ou de choisir des paramètres de réseau neuronal associés à l'un des nœuds descendants du nœud racine.

9. Décodeur (100, 100b) selon l'une quelconque des revendications précédentes, dans lequel les informations de mise à jour de paramètre (116, 526, 536, 546, 556, 566, 576, 586, 596, 606, 616, 626) comprennent une instruction de mise à jour (526, 536, 546, 556, 566, 586) définissant une addition d'une ou plusieurs valeurs de modification à une ou plusieurs valeurs de paramètre associées à un nœud parent d'un nœud actuellement considéré et/ou une soustraction d'une ou plusieurs valeurs de modification d'une ou plusieurs valeurs de paramètre associées à un nœud parent d'un nœud actuellement considéré ; et
dans lequel le décodeur est configuré pour appliquer une addition ou une soustraction des valeurs de modification définies par l'instruction de mise à jour, afin d'obtenir un ou plusieurs paramètres de réseau neuronal (522, 532, 542, 552, 562, 582) associés au nœud actuellement considéré.

10. Décodeur (100, 100b) selon l'une quelconque des revendications précédentes, dans lequel le décodeur est configuré pour déterminer si un identifiant de nœud parent (114, 524, 534, 544, 554, 564, 574, 584, 594, 604, 614, 624) est présent ; et
dans lequel le décodeur est configuré pour déduire un ou plusieurs paramètres de réseau neuronal selon l'une quelconque des revendications précédentes si l'identifiant de nœud parent (114, 524, 534, 544, 554, 564, 574, 584, 594, 604, 614, 624) est présent, et
dans lequel le décodeur est configuré pour faire du nœud actuellement considéré le nœud racine (510) si l'identifiant du nœud parent n'est pas présent.

11. Décodeur (100, 100b) selon l'une quelconque des revendications précédentes, dans lequel le décodeur est configuré pour comparer l'identifiant du nœud parent (114, 524, 534, 544, 554, 564, 574, 584, 594, 604, 614, 624) à des valeurs de hachage associées à un ou plusieurs nœuds, afin d'identifier le nœud parent du nœud actuellement considéré.

12. Décodeur (100, 100b) selon la revendication 11, dans lequel les valeurs de hachage sont les valeurs de hachage d'une partie de charge utile d'une unité de données compressées (NDU) associée à un ou plusieurs nœuds précédemment décodés, tout en ne prenant pas en compte une information de taille de données et une information d'en-tête.

13. Décodeur (100, 100b) selon l'une quelconque des revendications 11 à 12, dans lequel l'identifiant de nœud parent (114, 524, 534, 544, 554, 564, 574, 584, 594, 604, 614, 624) est une valeur combinée représentant un identifiant de dispositif et un numéro de série, tous deux étant associés au nœud parent.

14. Décodeur (100, 100b) selon l'une quelconque des revendications 1 à 13,
dans lequel les informations de nœud (112, 112b) comprennent un identifiant de nœud.

15. Décodeur (100, 100b) selon l'une quelconque des revendications 1 à 14,
dans lequel le décodeur est configuré pour stocker l'identifiant du nœud.

16. Décodeur (100, 100b) selon l'une quelconque des revendications 1 à 15,
dans lequel le décodeur est configuré pour comparer un ou plusieurs identifiants de nœuds stockés à un identifiant de nœud parent (114, 524, 534, 544, 554, 564, 574, 584, 594, 604, 614, 624) figurant dans les informations de nœud (112, 112b) d'un nouveau nœud lors de l'ajout du nouveau nœud, afin d'identifier un nœud parent du nouveau nœud.

17. Décodeur (100, 100b) selon l'une quelconque des revendications 1 à 16,
dans lequel l'identifiant de nœud comprend un identifiant de dispositif et/ou une information de la profondeur de l'arbre de mise à jour de paramètre et/ou un identifiant de l'arbre de mise à jour de paramètre.

18. Décodeur (100, 100b) selon l'une quelconque des revendications 1 à 17,
dans lequel les informations de nœud (112, 112b) comprennent une signalisation indiquant si un identifiant de nœud est présent ou non.

19. Décodeur (100, 100b) selon l'une quelconque des revendications 10 à 18, dans lequel le décodeur est configuré pour obtenir une signalisation (202, 302, 302b) comprenant une information relative au type de l'identifiant du nœud parent (114, 524, 534, 544, 554, 564, 574, 584, 594, 604, 614, 624), et dans lequel le décodeur est configuré pour évaluer la signalisation afin de prendre en compte le type respectif de l'identifiant de nœud parent.

20. Décodeur (100, 100b) selon l'une des revendications 1 à 19, dans lequel le décodeur est configuré pour évaluer de manière sélective un élément syntaxique qui indique un type de l'identifiant du nœud parent, en fonction d'un élément syntaxique indiquant la présence de l'identifiant du nœud parent (114, 524, 534, 544, 554, 564, 574, 584, 594, 604, 614, 624).

21. Codeur (200, 300, 300b, 400) destiné à coder des paramètres d'un réseau neuronal afin d'obtenir un flux binaire codé,
dans lequel le codeur est configuré pour fournir une information de nœud (212, 312, 312b, 412) décrivant un nœud d'un arbre (500) de mise à jour de paramètre, l'arbre de mise à jour de paramètre comprenant des nœuds qui sont dans un ordre hiérarchique ;
dans lequel les informations de nœud comprennent un identifiant de nœud parent (214, 314, 524, 534, 544, 554, 564, 574, 584, 594, 604, 614, 624), et
dans lequel les informations de nœud comprennent des informations de mise à jour de paramètre (216, 316, 416, 526, 536, 546, 556, 566, 576, 586, 596, 606, 616, 626) ;
dans lequel les informations de mise à jour de paramètre décrivent des différences entre des paramètres du réseau neuronal associés à un nœud parent défini par l'identifiant du nœud parent et un ou plusieurs paramètres actuels du réseau neuronal ;
dans lequel le codeur est configuré pour déterminer des différences entre un ou plusieurs paramètres de réseau neuronal définis par le nœud parent, qui est identifié par l'identifiant de nœud parent (214, 314, 524, 534, 544, 554, 564, 574, 584, 594, 604, 614, 624), et l'un ou les plusieurs paramètres actuels du réseau neuronal, afin d'obtenir les informations de mise à jour de paramètre (216, 316, 416, 526, 536, 546, 556, 566, 576, 586, 596, 606, 616, 626) ;
dans lequel le codeur est configuré pour fournir les informations de nœud (212, 312, 312b, 412) de sorte qu'il soit possible d'obtenir un ou plusieurs paramètres de réseau neuronal associés à un nœud actuellement considéré à l'aide des informations de mise à jour de paramètre (216, 316, 416, 526, 536, 546, 556, 566, 576, 586, 596, 606, 616, 626) associées au nœud actuellement considéré, à l'aide d'informations de paramètres associées à un nœud racine (510) et à l'aide d'informations de mise à jour de paramètre associées à un ou plusieurs nœuds intermédiaires qui sont entre le nœud racine et le nœud actuellement considéré dans l'arbre de mise à jour.

22. Procédé (1000) de décodage des paramètres d'un réseau neuronal, le procédé comprenant le fait
d'obtenir (1010) une pluralité de paramètres de réseau neuronal du réseau neuronal sur la base d'un flux binaire codé ;
d'obtenir (1020) des informations de nœud décrivant un nœud d'un arbre de mise à jour de paramètre, l'arbre de mise à jour de paramètre comprenant des nœuds organisés selon un ordre hiérarchique ;
dans lequel les informations de nœud comprennent un identifiant de nœud parent, et
dans lequel les informations de nœud comprennent des informations de mise à jour de paramètre ; et
de déterminer (1030) un ou plusieurs paramètres de réseau neuronal à l'aide des informations de paramètre d'un nœud parent identifié par l'identifiant de nœud parent et à l'aide des informations de mise à jour de paramètre ;
dans lequel le nœud parent comprend un identifiant propre au nœud parent et des informations propres à la mise à jour de paramètre, et
dans lequel le procédé comprend par ailleurs le fait de
déterminer de manière récursive des nœuds prédécesseurs du nœud parent jusqu'à ce qu'un nœud soit atteint pour lequel des paramètres de réseau neuronal sont disponibles, et
mettre à jour ces paramètres de réseau neuronal sur la base des informations de mise à jour des paramètres des nœuds dérivés, du nœud parent et des informations de mise à jour de paramètre issues des informations de nœud.

23. Procédé (1100) de codage de paramètres d'un réseau neuronal afin d'obtenir un flux binaire codé, le procédé comprenant le fait de
fournir (1110) des informations de nœud décrivant un nœud d'un arbre de mise à jour de paramètre, l'arbre de mise à jour de paramètre comprenant des nœuds qui sont dans un ordre hiérarchique ;
dans lequel les informations de nœud comprennent un identifiant de nœud parent, et
dans lequel les informations de nœud comprennent des informations de mise à jour de paramètre ;
dans lequel les informations de mise à jour de paramètre décrivent les différences entre les paramètres du réseau neuronal associés à un nœud parent défini par l'identifiant du nœud parent et un ou plusieurs paramètres actuels du réseau neuronal ;
dans lequel le procédé comprend par ailleurs le fait de
déterminer les différences entre un ou plusieurs paramètres de réseau neuronal définis par le nœud parent, qui est identifié par l'identifiant de nœud parent (214, 314, 524, 534, 544, 554, 564, 574, 584, 594, 604, 614, 624), et l'un ou les plusieurs paramètres actuels du réseau neuronal, afin d'obtenir les informations de mise à jour de paramètre (216, 316, 416, 526, 536, 546, 556, 566, 576, 586, 596, 606, 616, 626) ; et
fournir des informations de nœud (212, 312, 312b, 412), de sorte qu'il soit possible d'obtenir un ou plusieurs paramètres de réseau neuronal associés à un nœud actuellement considéré à l'aide des informations de mise à jour de paramètre (216, 316, 416, 526, 536, 546, 556, 566, 576, 586, 596, 606, 616, 626) associées au nœud actuellement considéré, à l'aide d'informations de paramètre associées à un nœud racine (510) et à l'aide d'informations de mise à jour de paramètre associées à un ou plusieurs nœuds intermédiaires qui sont entre le nœud racine et le nœud actuellement considéré dans l'arbre de mise à jour.

24. Programme informatique permettant de mettre en œuvre le procédé selon l'une des revendications 22 à 23, lorsque le programme informatique est exécuté sur un ordinateur.
